(19) Europäisches Patentamt
European Patent Office
Office européen des brevets

(11) EP 4 531 089 A1

(12) EUROPEAN PATENT APPLICATION

(43) Date of publication:
**02.04.2025 Bulletin 2025/14**

(21) Application number: **24179631.7**

(22) Date of filing: **03.06.2024**

(51) International Patent Classification (IPC):
***H01L 23/00*** *(2006.01)*

(52) Cooperative Patent Classification (CPC):
**B23K 35/0233; B23K 35/0244; H01L 23/14; H01L 24/83**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.06.2023 JP 2023098780**

(71) Applicant: **NITTO DENKO CORPORATION**
**Ibaraki-shi**
**Osaka 567-8680 (JP)**

(72) Inventors:
- **Kamei, Katsutoshi**
  **Ibaraki-shi, Osaka, 567-8680 (JP)**
- **Mita, Ryota**
  **Ibaraki-shi, Osaka, 567-8680 (JP)**
- **Okoba, Yuichi**
  **Ibaraki-shi, Osaka, 567-8680 (JP)**

(74) Representative: **Grünecker Patent- und Rechtsanwälte**
**PartG mbB**
**Leopoldstraße 4**
**80802 München (DE)**

# (54) SINTER BONDING SHEET ROLL

(57) A sinter bonding sheet roll according to the present invention includes a first substrate and a sinter bonding layer laminated on the first substrate, and is formed by winding, in a length direction, a sinter bonding sheet that is formed into a band shape, in which the sinter bonding layer includes sinterable particles containing a conductive metal, and an organic binder, and is directly laminated on the first substrate or is indirectly laminated on the first substrate via a second substrate interposed therebetween, and a longitudinal dimension $L_1$ of the first substrate is larger than any of a longitudinal dimension $L_S$ of the sinter bonding layer and a longitudinal dimension $L_2$ of the second substrate.

Fig. 1A

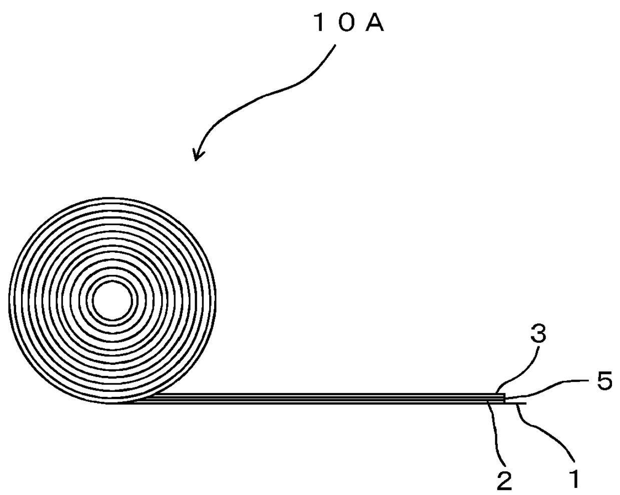




Processed by Luminess, 75001 PARIS (FR)

## Description

FIELD OF THE INVENTION

The present invention relates to a sinter bonding sheet roll. Specifically, the present invention relates to a sinter bonding sheet roll formed by winding, in a length direction, a sinter bonding sheet that is formed into a band shape.

BACKGROUND OF THE INVENTION

There is conventionally known a method for mounting a semiconductor device on a substrate having a semiconductor device mounting area by means of a sinter bonding layer in producing a semiconductor apparatus (for example, JP 2020-150188 A). JP 2020-150188 A describes that the sinter bonding layer is formed as a layer including sinterable particles and an organic binder. The production of the semiconductor apparatus is performed, for example, using a sinter bonding sheet having a substrate and a sinter bonding layer laminated on the substrate, and the sinter bonding sheet is generally formed into a band shape having a length direction and a width direction.

The production of the semiconductor apparatus as aforementioned is performed, for example, with the following steps.

(1) A semiconductor wafer is attached to an adhesive layer of a dicing tape that includes a substrate and the adhesive layer laminated on the substrate. Then, the semiconductor wafer that is attached to the adhesive layer is subjected to dicing to be formed into a plurality of individual semiconductor devices.

(2) One semiconductor device is picked up using a jig such as a collet from the adhesive layer of the dicing tape. Then, the one semiconductor device is pressed onto a sinter bonding layer provided in a sinter bonding sheet, to cut a part of the sinter bonding layer into segments so as to each have a size corresponding to the size of the one semiconductor device. The sinter bonding layer divided as described above is adhered to the one semiconductor device by an organic binder that exists on a surface in abutting contact with the one semiconductor device, to thereby allow the divided sinter bonding layer to be transferred to the one semiconductor device.

(3) The one semiconductor device, to which the divided sinter bonding layer is transferred, is adhered to one semiconductor device mounting area on the substrate having a plurality of semiconductor device mounting areas by the organic binder that exists on a surface on the opposite side to the surface in abutting contact with the one semiconductor device. That is, the one semiconductor device is temporarily fixed to the one semiconductor device mounting area of the substrate by the organic binder.

(4) The steps in the above (2) and (3) are repeated several times, to thereby allow the plurality of semiconductor devices to be temporarily fixed to the plurality of semiconductor device mounting areas by the divided sinter bonding layers, respectively. Thereby, an intermediate product of the semiconductor apparatus is obtained.

(5) The intermediate product of the semiconductor apparatus is heated at a temperature at which the sinterable particles can be sintered to each other, to cause at least a part of the organic binder to be burned out from the sinter bonding layer, while allowing the sinterable particles to be sintered to each other in the sinter bonding layer. Thereby, the plurality of semiconductor devices are respectively bonded to the semiconductor device mounting areas in the substrate. After these steps are performed, the plurality of semiconductor devices are respectively fixed to the semiconductor device mounting areas in the substrate by sintering the sinterable particles included in the divided sinter bonding layers. That is, a sintered body formed by sintering the sinterable particles allows the plurality of semiconductor devices to be fixed to the semiconductor device mounting areas of the substrate, respectively.

There is also conventionally known a sheet roll (hereinafter referred to as the sinter bonding sheet roll) formed by winding, in a length direction, the band-shaped sinter bonding sheet formed as described above (for example, JP 2020-147706 A). In producing the semiconductor apparatus using the aforementioned sinter bonding sheet roll, the above step (2) is sometimes performed using a roll-to-roll machine including a feed roller and a winding roller. Specifically, there may be a case where, while the sinter bonding sheet roll attached to the feed roller is fed toward the winding roller along the length direction, the one semiconductor device is pressed onto a sinter bonding layer provided in a sinter bonding sheet roll using a jig such as a collet, to cut a part of the sinter bonding layer into segments so as to each have a size corresponding to the size of the one semiconductor device, to thereby allow the divided sinter bonding layer to be transferred to the one semiconductor device.

## SUMMARY OF THE INVENTION

### Technical Problem

In producing the semiconductor apparatus using the band-shaped sinter bonding sheet roll as aforementioned, there is a case where an effective transferring area for a semiconductor device cannot be sufficiently secured on the sinter bonding layer of the sinter bonding sheet roll. When the effective area in the sinter bonding layer cannot be sufficiently secured, the ratio of the area of the sinter bonding layer available for transferring relative to the entire sinter bonding layer reduces. As a result, a production yield of the semiconductor apparatus (specifically, a utilization ratio of the sinter bonding layer) reduces. Nevertheless, no sufficient consideration appears to have been made on suppressing the reduction in the production yield of the semiconductor apparatus using the sinter bonding sheet roll.
It is therefore an object of the present invention to provide a sinter bonding sheet roll capable of suppressing the reduction in the production yield of the semiconductor apparatus.

### Solution to Problem

A sinter bonding sheet roll according to the present invention includes a first substrate and a sinter bonding layer laminated on the first substrate, and is formed by winding, in a length direction, a sinter bonding sheet that is formed into a band shape, in which

the sinter bonding layer includes sinterable particles containing a conductive metal, and an organic binder, and is directly laminated on the first substrate or is indirectly laminated on the first substrate via a second substrate interposed therebetween, and
a longitudinal dimension $L_1$ of the first substrate is larger than any of a longitudinal dimension $L_S$ of the sinter bonding layer and a longitudinal dimension $L_2$ of the second substrate.

## BRIEF DESCRIPTION OF DRAWINGS

Fig. 1A is a side view showing a configuration of a sinter bonding sheet roll according to an embodiment of the present invention.
Fig. 1B is a perspective view showing a configuration of a sinter bonding sheet (sinter bonding sheet before being wound) for obtaining the sinter bonding sheet roll according to the embodiment of the present invention.
Fig. 2 is cross-sectional view showing another configuration of the sinter bonding sheet.
Fig. 3A is a side view showing a configuration of a sinter bonding sheet roll according to another embodiment of the present invention.
Fig. 3B is a perspective view showing a configuration of a sinter bonding sheet (sinter bonding sheet before being wound) for obtaining the sinter bonding sheet roll according to the other embodiment of the present invention.
Fig. 4A is a schematic sectional view showing a state where a first semiconductor chip is picked up from a dicing tape by a collet.
Fig. 4B is a schematic sectional view showing a state where a second semiconductor chip is picked up from the dicing tape by the collet.
Fig. 5 is a schematic view showing a state where the sinter bonding sheet roll according to an embodiment is conveyed by a roll-to-roll machine.
Fig. 6A is a schematic sectional view showing a state where a part of a sinter bonding layer of the sinter bonding sheet according to an embodiment is transferred to the first semiconductor chip.
Fig. 6B is a schematic sectional view showing a state where a part of the sinter bonding layer of the sinter bonding sheet according to the embodiment is transferred to the second semiconductor chip.
Fig. 7A is a schematic sectional view showing a state where the first semiconductor chip with a divided body of a sinter bonding layer is picked up by the collet.
Fig. 7B is a schematic sectional view showing a state where the second semiconductor chip with a divided body of the sinter bonding layer is picked up by the collet.
Fig. 8A is a schematic sectional view showing a state where the first semiconductor chip with a divided body of the sinter bonding layer is temporarily fixed to a first die pad of a lead frame substrate.
Fig. 8B is a schematic sectional view showing a state where the second semiconductor chip with a divided body of the sinter bonding layer is temporarily fixed to a second die pad of the lead frame substrate.
Fig. 9A is a schematic sectional view showing an example of a state of heating the lead frame substrate, in which the

first semiconductor chip is temporarily fixed to the first die pad via a divided body of the sinter bonding layer, and the second semiconductor ship is temporarily fixed to the second die pad via a divided body of the sinter bonding layer. Fig. 9B is a schematic sectional view showing another example of a state of heating the lead frame substrate, in which the first semiconductor chip is temporarily fixed to the first die pad via a divided body of the sinter bonding layer, and the second semiconductor ship is temporarily fixed to the second die pad via a divided body of the sinter bonding layer.

DETAILED DESCRIPTION OF THE PREFERRED EMBODIMENT

Hereinafter, a description will be given on one embodiment of the present invention. The one embodiment of the present invention herein may be simply referred to as this embodiment.

(Sinter bonding sheet roll)

As shown in Fig. 1A, a sinter bonding sheet roll 10A according to this embodiment is formed by winding, in a length direction L, a band-shaped sinter bonding sheet 10B as shown in Fig. 1B. As shown in Fig. 1B, the band-shaped sinter bonding sheet 10B includes a first substrate 1 and a sinter bonding layer 5 laminated on the first substrate 1. The sinter bonding sheet roll 10A according to this embodiment also includes the first substrate 1 and the sinter bonding layer 5 laminated on the first substrate 1 in the same manner as the sinter bonding sheet 10B (see Fig. 1A). In the sinter bonding sheet roll 10A and the sinter bonding sheet 10B according to this embodiment, the sinter bonding layer 5 includes sinterable particles containing a conductive metal, and an organic binder. The conductive metal herein means a metal having an electric conductivity of 100 μS/ cm or less measured according to JIS K 0130 (2008).

In the sinter bonding sheet roll 10A and the sinter bonding sheet 10B according to this embodiment, the sinter bonding layer 5 is indirectly laminated on the first substrate 1 with a second substrate 2 interposed therebetween. The sinter bonding layer 5 can be directly laminated on the first substrate 1.

In the sinter bonding sheet roll 10A and the sinter bonding sheet 10B according to this embodiment, as shown in Fig. 1A and Fig. 1B, a third substrate 3 is disposed on an opposite surface of the sinter bonding layer 5 which is on the opposite side to the surface facing the first substrate 1. The sinter bonding layer 5 can be provided with no third substrate 3 on the opposite surface. That is, the opposite surface of the sinter bonding layer 5 can be an exposed surface.

In the sinter bonding sheet roll 10A and the sinter bonding sheet 10B according to this embodiment, a longitudinal dimension $L_1$ of the first substrate 1 is larger than any of a longitudinal dimension $L_S$ of the sinter bonding layer 5 and a longitudinal dimension $L_2$ of the second substrate 2 (see, in particular, Fig. 1B). Compared to a sinter bonding sheet roll without including the aforementioned first substrate 1, it is possible to sufficiently use the sinter bonding layer 5 up to its both end portions in the length direction by inclusion of the first substrate 1 in the sinter bonding sheet roll 10A, when a part of the sinter bonding layer 5 is transferred to each of the plurality of semiconductor chips while conveying the sinter bonding sheet roll 10A along the length direction by a roll-to-roll machine 1000 as described later. That is, an effective area in the length direction for transferring each of the plurality of semiconductor chips in the sinter boding layer 5 can be sufficiently secured. Thus, it is possible to suppress the reduction in the production yield (specifically, the utilization ratio of the sinter bonding layer in the length direction) when the semiconductor apparatus is produced using a roll-to-roll machine.

The longitudinal dimension $L_1$ of the first substrate 1 is preferably 3000 mm (3 m) or more and 120000 mm (120 m) or less. The longitudinal dimension $L_2$ of the second substrate 2 and the longitudinal dimension $L_S$ of the sinter bonding layer 5 each are preferably 1000 mm (1 m) or more and 100000 mm (100 mm) or less. The longitudinal dimension $L_2$ of the second substrate 2 and the longitudinal dimension $L_S$ of the sinter bonding layer 5 can be the same or can be different from each other, but are preferably the same.

In terms of sufficiently securing the utilization ratio of the sinter bonding layer 5 in the length direction, $L_1$ is preferably 1.1 times or more, more preferably 1.2 time or more, further preferably 1.3 times or more, of $L_S$. When $L_1$ is excessively larger than Ls, the roll-to-roll machine 1000 to be described later may cause a delay of the timing to start the transfer of a part of the sinter bonding layer to a first semiconductor chip B1, or may take an excessive time to wind up the used sinter bonding sheet 10B around a winding roller after a part of the sinter bonding layer is transferred to each of the plurality of semiconductor chips. In order to suppress these problems, $L_1$ can be 3.0 times or less, can be 2.0 times or less, can be 1.8 times or less, or can be 1.6 times or less, of $L_S$. $L_1$ is preferably 1.1 times or more, more preferably 1.2 times or more, further preferably 1.3 times or more, of $L_2$. $L_1$ can be 3.0 times or less, can be 2.0 times or less, can be 1.8 times or less, or can be 1.6 times or less, of $L_2$. As described above, $L_S$ and $L_2$ can be the same or can be different from each other, but are preferably the same. $L_2$ preferably falls within the range of 0.8 times or more and 1.2 times or less of $L_S$, more preferably falls within the range of 0.9 times or more and 1.1 times or less of Ls.

A distance ΔL1 between one end in the length direction of the first substrate 1 and one end in the length direction of the sinter bonding layer 5 can be 3000 mm (3 m) or more, can be 5000 mm (5 m) or more, or can be 10000 mm (10 m) or more. The ΔL1 can be 20000 mm (20 m) or less, or can be 15000 mm (15 m) or less. A distance ΔL2 between another end in the length direction of the first substrate 1 and another end in the length direction of the sinter bonding layer 5 can be in the

same relationship with that of ΔL1. ΔL1 and ΔL2 can be appropriately selected according to the roll-to-roll machine in which the sinter bonding sheet roll 10A according to this embodiment is used. For example, when the roll-to-roll machine 1000 as shown in Fig. 5 is used, ΔL1 and ΔL2 can be appropriately set according to ΔD1 and ΔD2, in which ΔD1 represents the distance between a shaft of a feed roller 100 and one end in a transfer stage G facing the shaft (i.e., closest to the shaft), and ΔD2 represents the distance between a shaft of a second winding roller 200b and another end in the transfer stage G facing the shaft (i.e., closest to the shaft). Further, when the roll-to-roll machine 1000 as shown in Fig. 5 is used, it is preferable that at least one of ΔD1 and ΔD2 be equal to or more than a conveying distance from a feed end LE of the feed roller 100 to a winding end WE of the second winding roller 200b. Moreover, it is more preferable that ΔD1 and ΔD2 each be equal to or more than the conveying distance. With ΔD1 being equal to or more than the conveying distance, it is possible to secure a sufficient feed length when feeding the sinter bonding sheet roll 10A from the feed roller 100. Thereby, it is possible to eliminate the work for extending the length of one end side in the length direction of the first substrate 1 by jointing the one end side of the first substrate 1 to another substrate. As a result, the sinter bonding sheet roll 10A can be efficiently fed from the feed roller 100. With ΔD2 being equal to or more than the conveying distance, it is possible to secure a sufficient winding length when winding the sinter bonding sheet roll 10A (i.e., the used sinter bonding sheet roll 10A) after the sinter bonding layer 5 is transferred by the second winding roller 200b. Thereby, it is possible to eliminate the work for extending the length of another end side in the length direction of the first substrate 1 by jointing the other side of the first substrate 1 to another substrate. As a result, the used sinter bonding sheet roll 10A can be efficiently wound up by the second winding roller 200b. The conveying distance herein means the distance from a feed end LE of the feed roller 100 to a winding end WE of the second winding roller 200b via a first conveying roller 101, a second conveying roller 102, a third conveying roller 103, the transfer stage G, and a fourth conveying roller 104.

A longitudinal dimension $L_3$ of the third substrate 3 and the longitudinal dimension $L_S$ of the sinter bonding layer 5 can be the same or can be different from each other, but are preferably the same $L_3$ preferably falls within the range of 0.8 times or more and 1.2 times or less of $L_S$, more preferably falls within the range of 0.9 times or more and 1.1 times or less of $L_S$.

In the sinter bonding sheet roll 10A and the sinter bonding sheet 10B according to this embodiment, the sinter bonding layer 5 and the second substrate 2 are continuously laminated on the first substrate 1 along the length direction (see Fig. 1A and Fig. 1B). On the other hand, the sinter bonding layer 5 and the second substrate 2 can be intermittently laminated on the first substrate 1 along the length direction as shown in Fig. 2. In the case where the sinter bonding layer 5 and the second substrate 2 are intermittently laminated on the first substrate 1 along the length direction as shown in Fig. 2, the third substrate 3 also can be intermittently laminated on the sinter bonding layer 5. In the case where the sinter bonding sheet roll 10A is formed by winding the sinter bonding sheet 10B in the length direction as shown in Fig. 2, it is a matter of course that the sinter bonding layer 5, the second substrate 2, and the third substrate 3 are intermittently laminated on the first substrate 1 along the length direction in the sinter bonding sheet roll 10A.

In the sinter bonding sheet roll 10A and the sinter bonding sheet 10B according to this embodiment, a surface area $S_1$ of the first substrate 1 in plan view is preferably larger than any of a surface area $S_S$ of the sinter bonding layer 5 in plan view and a surface area $S_2$ of the second substrate 2 in plan view. With the surface area $S_1$ of the first substrate 1 in plan view being larger than any of a surface area $S_S$ of the sinter bonding layer 5 in plan view and a surface area $S_2$ of the second substrate 2 in plan view, the first substrate 1 can be extended outward from the sinter bonding layer 5 and the second substrate 2 in at least one of a length direction L and a width direction W of the sinter bonding sheet roll 10A and the sinter bonding sheet 10B. In the case where the first substrate 1 is extended outward from the sinter bonding layer 5 and the second substrate 2 in the length direction L, an effective area in the length direction L for transferring each of the plurality of semiconductor chips in the sinter bonding layer 5 can be sufficiently secured, as described above. Thus, it is possible to suppress the reduction in the production yield (specifically, the utilization ratio of the sinter bonding layer 5 in the length direction L) when the semiconductor apparatus is produced using a roll-to-roll machine 1000, as described later.

Further, when a part of the sinter bonding layer 5 is transferred to each of the plurality of semiconductor chips, while feeding the sinter bonding sheet roll 10A along the length direction L by the roll-to-roll machine 1000, both end portions in the width direction W of the sinter bonding sheet roll 10A that has been fed is held on the transfer stage 5 by, for example, a jig. Therefore, if the sinter bonding layer 5 is formed over both end portions in the width direction W of the sinter bonding sheet roll 10A, portions of the sinter bonding layer 5 to be held by the jig increase. However, in the case where the first substrate 1 is extended outward from the sinter bonding layer 5 and the second substrate 2 in the width direction W, a portion on each of both end sides in the width direction W of the sinter bonding layer 5 to be held by the jig can be decreased or eliminated. Thereby, an effective area in the width direction W for transferring each of the plurality of semiconductor chips in the sinter bonding layer 5 can be sufficiently secured. As a result, it is possible to suppress the reduction in the production yield (specifically, the utilization ratio of the sinter bonding layer 5 in the width direction W) when the semiconductor apparatus is produced using a roll-to-roll machine.

In the case where the first substrate 1 can be extended outward from the sinter bonding layer 5 and the second substrate 2 in both of the length direction L and the width direction W, it is possible to suppress the reduction in the utilization ratio of the sinter bonding layer 5 in both of the length direction L and the width direction W.

The surface area $S_1$ is preferably 1.5 times or more, more preferably 1.8 times or more, further preferably 2.0 times or more, of the surface area $S_S$. The surface area $S_1$ can be 3.0 times or less, can be 2.5 times or less, or can be 2.2 times or less, of the surface area $S_S$. In the case where the sinter bonding layer 5 is intermittently laminated on the first substrate 1, the surface area $S_S$ means a total value of the areas of the intermittently-laminated individual parts of the sinter bonding layer 5. In the case where the second substrate 2 is intermittently laminated on the first substrate 1, the surface area $S_2$ means a total value of the areas of the intermittently-laminated individual parts of the second substrate 2.

The surface area $S_1$ of the first substrate 1 in plan view is preferably larger than a surface area $S_3$ of the third substrate 3 in plan view. The surface area $S_1$ is preferably 1.5 times or more, more preferably 1.8 times or more, further preferably 2.0 times or more, of the surface area $S_3$. The surface area $S_1$ can be 3.0 times or less, can be 2.5 times or less, or can be 2.2 times or less, of the surface area $S_3$. In the case where the third substrate 3 is intermittently laminated on the sinter bonding layer 5, the surface area $S_3$ means a total value of the areas of the intermittently-laminated individual parts of the third substrate 3.

A width dimension $W_1$ of the first substrate 1 is preferably larger than any of a width dimension $W_S$ of the sinter bonding layer 5 and a width dimension $W_2$ of the second substrate 2. Thereby, it is possible to further suppress the reduction in the production yield (specifically, the utilization ratio of the sinter bonding layer 5 in the width direction W) when the semiconductor apparatus is produced using the roll-to-roll machine 1000, as described later.

The width dimension $W_1$ of the first substrate 1 is preferably 20 mm (2 cm) or more and 1000 mm (100 cm) or less. The width dimension $W_2$ of the second substrate 2 and the width dimension $W_S$ of the sinter bonding layer 5 each are preferably 10 mm (1 cm) or more and 500 mm (50 cm) or less. The width dimension $W_2$ of the second substrate 2 and the width dimension $W_S$ of the sinter bonding layer 5 can be the same or can be different from each other.

$W_1$ is preferably 1.1 times or more, more preferably 1.2 times or more, further preferably 1.3 times or more, of $W_S$. $W_1$ can be 2.0 times or less, can be 1.8 times or less, or can be 1.6 times or less, of $W_S$. $W_1$ is preferably 1.1 times or more, more preferably 1.2 times or more, further preferably 1.3 times or more, of $W_2$. $W_1$ can be 2.0 times or less, can be 1.8 times or less, or can be 1.6 times or less, of $W_2$. $W_s$ and $W_2$ can be the same or can be different from each other, but are preferably the same. $W_2$ preferably falls within the range of 0.8 times or more and 1.2 times or less, more preferably falls within the range of 0.9 times or more and 1.1 times or less, of $W_S$.

A distance $\Delta W1$ between one end in the width direction of the first substrate 1 and one end in the width direction of the sinter bonding layer 5 can be 3 mm or more, can be 5 mm or more, can be 10 mm or more, or can be 20 mm or more. $\Delta W1$ can be 100 mm or less, can be 50 mm or less, or can be 30 mm or less. A distance $\Delta W2$ between another end in the width direction of the first substrate 1 and another end in the width direction of the sinter bonding layer 5 can be in the same relationship as that of $\Delta W1$. $\Delta W1$ and $\Delta W2$ can be appropriately selected according to the dimension of each of both end portions to be held by a jig in the width direction of the first substrate 1 of the sinter bonding sheet roll 10A of this embodiment. For example, $\Delta W1$ and $\Delta W2$ each can be larger than the corresponding dimension to be held by the jig.

The width dimension $W_1$ of the first substrate 1 is preferably larger than the width dimension $W_3$ of the third substrate 3.

$W_1$ is preferably 1.1 times or more, more preferably 1.2 times or more, further preferably 1.3 times or more, of $W_3$. $W_1$ can be 2.0 times or less, can be 1.8 times or less, or can be 1.6 times or less, of $W_3$. $W_3$ and $W_S$ can be the same or can be different from each other, but are preferably the same. $W_3$ preferably falls within the range of 0.8 times or more and 1.2 times or less, more preferably falls within the range of 0.9 times or more and 1.1 times or less, of $W_S$.

The sinter bonding layer 5 of the sinter bonding sheet roll 10A and the sinter bonding sheet 10B is, via an organic binder included in the sinter bonding layer 5, temporarily fixed to a substrate or transferred to a semiconductor chip. That is, the organic binder is left in the sinter bonding layer 5 when the sinter bonding layer 5 is temporarily fixed to the substrate or transferred to the semiconductor chip. On the other hand, the sinter bonding layer 5 plays a role to bond the semiconductor chip to the substrate by the sinterable particles included in the sinter bonding layer 5 sintered to each other. That is, in the state where the semiconductor chip is bonded to the substrate, at least part of the organic binder in the sinter bonding layer 5 is burned out. Considering that the semiconductor chip is bonded to the substrate by sintering the sinterable particles to each other as described above, the residue of the organic binder in the sinter bonding layer 5 is preferably low as much as possible. That is, preferably almost no, more preferably no organic binder is left in the sinter bonding layer 5.

Examples of the conductive metal include gold, silver, copper, palladium, tin, and nickel. Also, the conductive metal can be an alloy of two or more metals selected from the group consisting of gold, silver, copper, palladium, tin, and nickel. Further, the conductive metal can be metal oxide such as silver oxide, copper oxide, palladium oxide, or tin oxide. In the sinter bonding sheet roll 10A and the sinter bonding sheet 10B according to this embodiment, the sinterable particles preferably contain, as the conductive metal, at least one selected from the group consisting of silver, copper, silver oxide, and copper oxide. The sinterable particles, which include as the conductive metal at least one selected from the group consisting of silver, copper, silver oxide, and copper oxide, can sufficiently improve, as described later, bonding properties by a divided sinter bonding layer 5 (i.e., divided body 2' of the sinter bonding layer) at the time of bonding a semiconductor device to a semiconductor device mounting area of the substrate via the divided sinter bonding layer 5 (i.e., divided body 2' of the sinter bonding layer). Further, the sinterable particles preferably contain silver or copper as the conductive metal in

terms of imparting high conductivity and high heat dissipation to the sinter bonding layer 2. Considering the oxidation resistance, silver is preferably used as the conductive metal. For example, when coper is used as the conductive metal in bonding the semiconductor device such as a semiconductor chip to a die pad of a lead frame substrate by sintering the sinterable particles in the divided sinter bonding layer 5 (i.e., divided body 2' of the sinter bonding layer), the bonding needs to be performed under inert environment such as under nitrogen atmosphere. However, when silver is used as the conductive metal, the bonding can be favorably performed even under air atmosphere. The sinterable particles in the sinter bonding sheet roll 10A and the sinter bonding sheet 10B according to this embodiment can be particles having a core-shell structure formed by a core part and a shell part covering the core part. The conductive metal forming the core part can include copper as a main component, and the conductive metal forming the shell part can include gold or silver as a main component.

Examples of the shape of the sinterable particles that can be used herein include a flake shape, a needle shape, a filament shape, a spherical shape, and a flat shape (including a scale shape). Among them, the sinterable particles having a spherical shape are preferably used. The use of particles having a spherical shape as the sinterable particles can improve the dispersion properties of the sinterable particles in a varnish, to be described later, for obtaining the sinter bonding layer 5.

The sinterable particles can be sintered at a heating temperature of 400 °C or less. The sinterable particles that can be sintered at a heating temperature of 400 °C or less herein mean sinterable particles in which necking is observed on the outer surfaces of adjacent particles when heated at a temperature of 400 °C or less. The sintering temperature of the sinterable particles can be measured using a thermogravimetric analyzer. Specifically, measurement is performed using a thermogravimetric analyzer (e.g., TG8120, a differential thermo-gravimetry manufactured by Rigaku Corporation) in the following conditions to obtain a Tg curve and a DTA curve, and determine a largest peak temperature of the DTA curve which appears around the start point of the downward slope of the Tg curve. Thereby, the sintering temperature of the sinterable particles can be obtained.

<Measurement conditions>

- Temperature rising rate: 10 °C/min
- Measurement atmosphere: Air atmosphere
- Measurement temperature range: Room temperature (23 ± 2 °C) to 500 °C

The sinterable particles including, as the conductive metal, gold, silver, copper, palladium, tin, or nickel and an alloy of these metals can be sintered at, for example, a heating temperature of 400 °C or less.

An average particle size of the sinterable particles is preferably 1 nm or more, more preferably 10 nm or more, further preferably 50 nm or more. The average particle size of the sinterable particles equal to or more than the above lower limit can improve dispersion properties of the sinterable particles in a varnish, to be described later, for obtaining the sinter bonding layer 5. In the sinter bonding layer 5 obtained in this way, the sinterable particles are favorably dispersed. The average particle size of the sinterable particles is preferably 10000 nm or less, more preferably 3000 nm or less, further preferably 1000 nm or less, still further preferably 500 nm or less. The average particle size of the sinterable particles equal to or less than the above upper limit can allow the sinter bonding layer 5 to have a relatively smooth surface. The average particle size of the sinterable particles can be determined by observing the cross section of the sinter bonding layer 5 using a scanning electron microscope (SEM). Specifically, the determination can be made with the following steps.

(1) A sinter bonding layer 5 having a plane dimension of 10 mm × 10 mm and a thickness of 50 μm (i.e., 0.05 mm) is prepared.
(2) The sinter bonding layer 5 and a chip having a second electrode (plane dimension: 10 mm× 10 mm, thickness: 3 mm) are disposed in this order on a substrate (plane dimension: 10 mm× 10 mm, thickness: 3 mm) having a first electrode on one surface to obtain a laminated body, followed by subjecting the laminated body to a sintering treatment to obtain a sinter bonding body. The sintering treatment is performed in the conditions of heating under a pressure of 10 MPa from 80 °C to 300°C at a temperature rising rate of 1.5 °C/sec, and then maintaining at 300 °C for 2.5 minutes. The sinter bonding layer 5 is disposed on the substrate to be in abutting contact with the first electrode, and the chip is disposed to have the second electrode in abutting contact with an exposed surface of the sinter bonding layer 5.
(3) An entire outer surface of the sinter bonding body is embedded in an embedding resin (for use in SEM), and then the outer surface of the embedded sinter bonding body is adjusted by polishing.
(4) The surface-adjusted sinter bonding body is cut along a thickness direction using a milling apparatus to obtain a sample for SEM observation.
(5) While the cutting surface of the sample for SEM observation is observed using a SEM, an image of the cutting

surface is captured to obtain an average particle size of the sinterable particles by analyzing the captured image. The image capturing is performed in the conditions at an accelerating voltage of 3 kV. The image analysis is performed using a SEM image magnified by 10,000 times or 100,000 times based on the size of the sinterable particles. The image analysis can be performed by subjecting the captured image to a binarization processing, to allow each of the sinterable particles included in the cutting surface to be identified. Then, a circle equivalent diameter of each of the sinterable particles included in the cutting surface is calculated, followed by arithmetically averaging the calculated values of the obtained circle equivalent diameter. Thereby, the average particle size of the sinterable particles can be determined. The sinterable particles of which an entire outline do not appear in the cutting surface are excluded from the subject for calculation of the circle equivalent diameter. The circle equivalent diameter herein means a diameter that can be obtained by calculating an area of a sinterable particle in the cutting surface, and then calculating based on a true circle having an area corresponding to the calculated area.

When the conductive metal is silver, that is, when the sinterable particles are silver particles, the silver particles can be silver particles composed of a silver element and another element included as an inevitable impurity element (e.g., metal element), or can be silver particles subjected to a surface treatment (e.g., silane coupling treatment). Examples of a surface treatment agent for the silver particles include a coating agent that is aliphatic acid-based, amine-based, or epoxy-based. The silver particles subjected to surface treatment with an aliphatic acid-based, amine-based, or epoxy-based coating agent may be hereinafter referred to as the silver particles treated with a coating agent. The use of the silver particles treated with a coating agent as the sinterable particles can increase affinity between the organic binder and the sinterable particles in the sinter bonding layer 5 before at least part of the organic binder is burned out by a heating treatment in, for example, the production of a semiconductor apparatus to be described later. Thereby, the sinterable metal particles become more easily dispersed in the sinter bonding layer 5 before at least part of the organic binder is burned out. At least part of the organic binder is burned out from the sinter bonding layer 5 by heating the sinter bonding layer 5 at a certain temperature or more as described in the production of a semiconductor apparatus to be described later.

In the sinter bonding sheet roll 10A and the sinter bonding sheet 10B according to this embodiment, the content percentage (SC) of the sinterable particles in the sinter bonding layer 5 is preferably 60 mass% or more and 99 mass% or less, more preferably 65 mass% or more and 98 mass% or less, further preferably 70 mass% or more and 97 mass% or less, still further preferably 85 mass% or more and 97 mass% or less. The content percentage (SC) of the sinterable particles within the above numerical range allows the sinterable particles to be sintered to each other in the sinter bonding layer 5, thereby enabling highly reliable bonding when a semiconductor device such as a semiconductor chip is bonded to a die pad of a lead frame substrate.

The content percentage (SC) of the sinterable particles in the sinter bonding layer 5 can be obtained by determining the amount of ash left after burning the sinter bonding layer 5. The content percentage (SC) of the sinterable particles can be measured using, for example, a thermogravimetric analyzer (e.g., TG209F1). The measurement using the thermogravimetric analyzer can be performed with the following steps.

(1) Using about 50 mg of the sinter bonding layer 5 as a measurement sample, the measurement sample is heated from room temperature (23 ± 2 °C) to 650 °C.
(2) The organic binder in the sinter bonding layer 5 is maintained at 650 °C for 30 minutes to be thereby thermally degraded.
(3) The ratio of the mass of the remaining component (ash) to the mass (about 50 mg) of the measurement sample before the heat treatment is determined.

The measurement using the thermogravimetric analyzer can be performed under an atmospheric air flow or can be performed under a nitrogen gas flow. In this regard, since the copper particles are susceptible to oxidization in the aforementioned temperature at the time of analysis, the measurement using the thermogravimetric analyzer is preferably performed under the nitrogen gas flow when the sinter bonding layer 5 includes the copper particles as the sinterable particles.

In the sinter bonding sheet roll 10A and the sinter bonding sheet 10B, the sinter bonding layer 5 preferably includes, as the organic binder, a first organic binder and a second organic binder having a molecular weight smaller than that of the first organic binder.

The first organic binder is preferably a thermally-degradable high molecular binder. The thermally-degradable high molecular binder is a binder thermally degraded during a high-temperature heating step for forming sintered bonds by sintering the sinterable particles. The thermally-degradable high molecular binder is an element contributing to, before the high-temperature heating step, keep the sinter bonding layer 5 in a sheet shape. In terms of securing the function of keeping the sinter bonding layer 5 in a sheet shape, the thermally-degradable high molecular binder is preferably a solid material at room temperature (23 ± 2 °C). Examples of the thermally-degradable high molecular binder include a polycarbonate resin and an acrylic resin. That is, the sinter bonding layer 5 preferably includes at least one of the

polycarbonate resin and the acrylic resin as the first organic binder. The sinter bonding layer 5 can include only the polycarbonate resin as the first organic binder.

Examples of the polycarbonate resin include an aliphatic polycarbonate composed of an aliphatic chain with no aromatic compound such as a benzene ring between the carbonate esters (-O-C-O-O-) of the main chain, and an aromatic polycarbonate having the aromatic compound between the carbonate esters (-O-C-O-O-) of the main chain. Examples of the aliphatic polycarbonate include polyethylene carbonate and polypropyrene carbonate. Examples of the aromatic polycarbonate include polycarbonate having a bisphenol-A structure in the main chain.

Examples of the acrylic resin include at least one of an acrylate ester polymer and a methacrylate ester polymer, having a linear or branched 4-18C alkyl group. Hereinafter, "(meth)acrylic" means at least one of "acrylic" and "methacrylic", and "(meth)acrylate" means at least one of "acrylate" and "methacrylate". Examples of the alkyl group of a (meth)acrylate ester for forming an acrylic resin as the thermally-degradable high molecular binder include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin can be a polymer including a monomer unit derived from a monomer other than the (meth) acrylate ester. Examples of the other monomer include a carboxy group-containing monomer, an acid anhydride monomer, a hydroxy group-containing monomer, a sulfonic acid group-containing monomer, and a phosphate group-containing monomer. Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylic acid, 2-hydroxypropyl (meth)acrylic acid, 4-hydroxybutyl (meth)acrylic acid, 6-hydroxyhexyl (meth)acrylic acid, 8-hydroxyoctyl (meth)acrylic acid, 10-hydroxydecyl (meth)acrylic acid, 12-hydroxylauryl (meth)acrylic acid, and 4-(hydroxymethyl) cyclohexylmethyl (meth)acrylic acid. Examples of the sulfonic acid group-containing monomer include styrenesulfonic acid, arylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid. Examples of the phosphate group-containing monomer include 2-hydroxyethyl acryloyl phosphate.

A volume-average molecular weight of the first organic binder is preferably 10000 or more. The volume-average molecular weight of the first organic binder means a value measured by a gel permeation chromatography (GPC) and converted in terms of polystyrene.

The second organic binder is preferably a low boiling point binder. The low boiling point binder is a binder component having a boiling point lower than the initial temperature of thermal decomposition of the thermally-degradable high molecular binder. In this embodiment, the low boiling point binder means a liquid binder or semiliquid binder having a viscosity of $1 \times 105$ Pa s at 23 °C when measured using a dynamic viscoelasticity measurement instrument (product name "HAAKE MARS III" manufactured by Thermo Fisher Scientific). The viscosity measurement herein is performed by using parallel plates having a diameter of 20 mm as a jig, setting a gap between the plates at 100 $\mu$m, and setting a shear rate in rotary shearing at $1s^{-1}$.

Examples of the low boiling point binder include terpene alcohols, alcohols other than terpene alcohols, alkylene glycol alkyl ethers, and ethers other than alkylene glycol alkyl ethers. Examples of the terpene alcohols include isobornyl cyclohexanol, citronellol, geraniol, nerol, carveol, and $\alpha$-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl methyl ether, dipropylene glycol propyl ether, dipropylene glycol butyl ether, and tripropylene glycol dimethyl ether. Examples of the ethers other than the alkylene glycol alkyl ethers include ethylene glycol ethyl ether acetate, ethylene glycol butyl ethyl acetate, diethylene glycol ethyl ether acetate, diethylene glycol butyl ethyl acetate, and dipropylene glycol methyl ether acetate. One of the low boiling point binders can be used individually, or two or more of them can be used in combination. As the low boiling point binder, the terpene alcohols are preferably used in terms of the stability at room temperature. Among the terpene alcohols, isobornyl cyclohexanol described above is preferably used.

Isobornyl cyclohexanol described above is a compound represented by formula (1) below. Isobornyl cyclohexanol described above is an organic compound having a boiling point of 308 °C to 318 °C, and has characteristics that, when heated under a nitrogen gas flow of 200 mL/min from room temperature (23 $\pm$ 2 °C) to 600 °C at a temperature rising rate of 10 °C/min, mass reduction becomes significant when the temperature reaches 100 °C and such significant mass reduction continues as the temperature increases, and volatilization and vanishment occurs (i.e., no further weight reduction is

found) at 245 °C. Isobornyl cyclohexanol has further characteristics that it has an extremely high viscosity of 1,000,000 Pa·s at 25 °C but has a relatively low viscosity of 1000 mPa s or less at 60 °C. The mass reduction refers to a value obtained when the mass reduction ratio at a measurement starting temperature (room temperature) is 0 %. Isobornyl cyclohexanol exhibits an extremely high viscosity at 25 °C as described above and thus can keep the thermosetting sheet in a sheet shape at room temperature. On the other hand, isobornyl cyclohexanol exhibits a relatively low viscosity at 60 °C as described above and thus has tackiness. That is, the sinter bonding sheet 10B having the sinter bonding layer 5 including isobornyl cyclohexanol tends to be excellent in capability of keeping itself in a sheet shape at room temperature, and have tackiness at 60 °C and higher. Here, when a semiconductor device bonded to one side of the sinter bonding layer 5 is mounted on a lead frame substrate or the like, it is general that the semiconductor device is temporarily attached (fixed) to an adherend such as the lead frame substrate or the like via the sinter bonding layer 5 at a temperature of 60 to 80 °C, in which isobornyl cyclohexanol has tackiness at 60 °C and higher as described above. Thus, in the case where the sinter bonding layer 5 in the sinter bonding sheet 10B according to this embodiment includes isobornyl cyclohexanol as the second organic binder, the capability of the sinter bonding layer 5 to an adherend such as a lead frame substrate is further improved. That is, the sinter bonding layer 5 in the temporarily fixed state suppresses the semiconductor device from being displaced from its mounting position, and is suppressed from rising from the adherend.

(Formula 1)

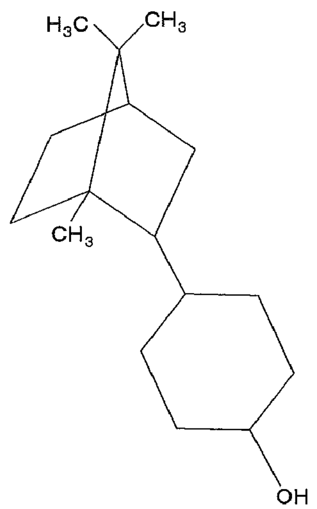

···(1)

In the case where the sinter bonding layer 5 includes, as the organic binder, the first organic binder and the second organic binder having a molecular weight smaller than that of the first organic binder, the content of the second organic binder can be higher than the content of the first organic binder. In such a case, $BC_1$ and $BC_2$ preferably satisfy the relationship of $BC_1:BC_2$ = 6:4 to 0.5:9.5, more preferably satisfy the relationship of $BC_1:BC_2$ = 5:5 to 1:9, further preferably satisfy the relationship of $BC_1:BC_2$ = 4:6 to 2:8, in which $BC_1$ mass% represents the content percentage of the first organic binder, and $BC_2$ mass% represents the content percentage of the second organic binder.

The content percentage $BC_1$ of the first organic binder is preferably 0.01 mass% or more, more preferably 0.05 mass% or more, further preferably 0.10 mass% or more, still further preferably 0.20 mass% or more. The content percentage $BC_1$ of the first organic binder is preferably 20 mass% or less, more preferably 10 mass% or less, further preferably 7.5 mass% or less, still further preferably 5.0 mass% or less.

The content percentage $BC_2$ of the second organic binder is preferably 0.5 mass% or more, more preferably 1.0 mass% or more, further preferably 1.5 mass% or more, still further preferably 2.0 mass% or more. The content percentage $BC_2$ of the second organic binder is preferably 20 mass% or less, more preferably 15 mass% or less, further preferably 10 mass% or less.

In the sinter bonding sheet roll 10A and the sinter bonding sheet 10B according to this embodiment, a thickness of the sinter bonding layer 5 is preferably 5 μm or more, more preferably 10 μm or more. In the sinter bonding sheet 10 according to this embodiment, the thickness of the sinter bonding layer 5 is preferably 300 μm or less, more preferably 150 μm or less. The thickness of the sinter bonding layer 2 can be obtained by, for example, measuring the thickness thereof at any 5 positions selected at random using a dial gauge (model R-205 manufactured by PEACOCK), followed by arithmetically averaging these thickness values.

The sinter bonding layer 5 can be produced by, for example, allowing the sinterable particles and the organic

binder to be dissolved or suspended in an organic solvent to prepare a varnish, applying the varnish on the first substrate 1 at a certain thickness to form a coating film, and then drying the coating film. As the organic solvent to prepare the varnish, for example, alcohols such as ethanol, or ketones such as methyl ethyl ketone (MEK) can be used.

The first substrate 1 functions as a support body in the sinter bonding sheet roll 10A of Fig. 1A and the sinter bonding sheet 10B of Fig. 1B. The first substrate 1 is made of, for example, a plastic substrate. A plastic film is preferably used as the plastic substrate. Examples of constituent materials of the plastic substrate include a polyolefin resin, a polyester resin, a polyurethane resin, a polycarbonate resin, a polyetheretherketone resin, a polyimide resin, a polyetherimide resin, a polytetrafluoroethylene resin, a polyamide resin, a wholly aromatic polyamide resin, a polyvinyl chloride resin, a polyvinylidene chloride resin, a polyphenyl sulfide resin, an aramid resin, a fluorine resin, a cellulose-based resin, and a silicone resin. Examples of the polyolefin resin include a polyethylene resin, a polypropylene resin, a polybutene resin, a polymethylpentene resin, an ethylene-vinyl acetate copolymer resin, an ionomer resin, an ethylene-butene copolymer resin, and an ethylene-hexene copolymer resin. Examples of the polyethylene resin include a low density polyethylene resin, a linear low density polyethylene resin, a medium density polyethylene resin, a high density polyethylene resin, and a very low density polyethylene resin. Examples of the polypropylene resin include a random copolymer polypropylene resin, a block copolymer polypropylene resin, and a homo polypropylene resin. Examples of the polyester resin include a polyethylene terephthalate resin, a polyethylene naphthalate resin, and a polybutylene terephthalate resin. The first substrate 1 can be composed of a single constituent material or can be composed of two or more constituent materials. The first substrate 1 can have a single layer structure or can have a multilayer structure. The single layer structure means a structure composed of one constituent material. For example, a structure in which two or more layers composed of one constituent material are laminated on each other is categorized as a single layer structure. In contrast, the multilayer structure means a structure in which two or more layers respectively composed of different constituent materials are laminated on each other. When the first substrate 1 is made of a plastic film, the first substrate 1 can be formed by a non-stretched film or can be formed by a stretched film. The stretched film can be a uniaxially stretched film or can be a biaxially stretched film.

The plastic substrate is preferably composed of the polyolefin resin, the polyester resin, the polyimide resin, or the polytetrafluoroethylene resin. The polyolefin resin is preferably the polyethylene resin. The polyester resin is preferably the polyethylene terephthalate resin. Examples of the commercially available product as the plastic substrate composed of the polyethylene resin include the product name "E-MASK (registered trademark) R-100" and the product name "E-MASK (registered trademark) R-200" manufactured by Nitto Denko Corporation, and the product name "SUNMAP LC-T5320T" manufactured by Nitto Denko Corporation. The "SUNMAP LC-T5320T" is a porous plastic substrate having a porosity of 30%. Examples of the commercially available product as the plastic substrate composed of the polyethylene terephthalate resin include the product name "E-MASK (registered trademark) CP170" manufactured by Nitto Denko Corporation. Examples of the commercially available product as the plastic substrate composed of the polyimide resin include the product name "TRM-6250L" manufactured by Nitto Denko Corporation. Examples of the commercially available product as the plastic substrate composed of the polytetrafluoroethylene resin include the product name "NIFTRON (registered trademark) 9030UL" manufactured by Nitto Denko Corporation.

The first substrate 1 preferably has a thickness of 30 μm or more and 150 μm or less. The first substrate 1 more preferably has a thickness of 31 μm or more, still more preferably has a thickness of 35 μm or more. The first substrate 1 more preferably has a thickness of 148 μm or less, still more preferably has a thickness of 145 μm or less. The thickness of the firstsubstrate 1 can be obtained by, for example, measuring the thickness thereof at any 5 positions selected at random using a dial gauge (model R-205 manufactured by PEACOCK), followed by arithmetically averaging these thickness values.

It is preferable that the first substrate 1 have a contact surface for contact with the sinter bonding layer 5 or the second substrate 2, and a Young's modulus at 23 °C obtained by measuring the contact surface using a nano-indentation method be 0.5 GPa or more and 5.0 GPa or less. With the Young's modulus being 5.0 GPa or less, a pressing force can be easily applied to the entire area of the sinter bonding layer 5 for contact with the first semiconductor chip B1 or the second semiconductor chip B2, when the first semiconductor chip B1 or the second semiconductor chip B2 is pressed to the sinter bonding layer 5 using a collet A as described later. As a result, a part of the sinter bonding layer 5 can be easily and sufficiently transferred to the first semiconductor chip B1 or the second semiconductor chip B2. Further, when the first semiconductor chip B1 or the second semiconductor chip B2 is pressed to the sinter bonding layer 5 using the collet A with the first substrate 1 disposed on a cushion member CM as described later, occurrence of a repulsive force to the first substrate 1 caused by the pressing can be sufficiently suppressed. As a result, a part of the sinter bonding layer 5 can be further sufficiently transferred to the first semiconductor chip B1 or the second semiconductor chip B2. With the Young's modulus being 0.5 GPa or more, when the first semiconductor chip B1 or the second semiconductor chip B2 is pressed to the sinter bonding layer 5 using the collet A as described later, a pressing force can be easily and sufficiently applied in a direction in which the first semiconductor chip B1 or the second semiconductor chip B2 is pressed. That is, the pressing force can be sufficiently suppressed from being dispersed in a direction other than the pressing direction, for example, a direction orthogonal to the pressing direction. As a result, a part of the sinter bonding layer 5 can be easily and sufficiently

transferred to the first semiconductor chip B1 or the second semiconductor chip B2.

The Young's modulus is more preferably 0.7 GPa or more, more preferably 0.9 GPa or more. The Young's modulus is more preferably 4.0 GPa or less, more preferably 3.5 GPa or less.

The Young's modulus can be obtained by the nano-indentation method according to ISO 14577 (instrumented indentation test). Specifically, the measurement can be performed using a micro hardness tester (DUH-211 manufactured by Shimadzu Corporation) in the following conditions.

· Indenter: Berkovich indenter
· Test mode: Loading-unloading test
· Test force: 0.98 mN
· Minimum test force: 0.002 mN
· Loading speed / unloading speed: 1.0 mN/sec
· Loading retention time: 5.0 sec
· Unloading retention time: 5.0 sec
· Cf-Ap correction adopted

The nano-indentation method is a method for measuring various physical properties of a sample by a nanometer scale. In the nano-indentation method, at least a step of pressing an indenter on the sample set on a stage (load application step) and a step of subsequently pulling out the indenter from the sample (unloading step) are performed to measure the load acting between the indenter and the sample and measure the relative displacement of the indenter with respect to the sample during the series of steps. As a result, a load-displacement curve can be obtained. Physical properties (such as a hardness, an elastic modulus, or an adhesive force) of the sample on the basis of the nanometer scale measurement can be obtained from the load-displacement curve.

The first substrate 1 has a tensile elongation at 23 °C of 4% or more and 350% or less. With the tensile elongation of first substrate 1 at 23 °C being 4% or more, when the sinter bonding sheet roll 10A is formed by winding the sinter bonding sheet 10B, peeling of the second substrate 2 from the first substrate 1 due to the difference in plan dimension between the first substrate 1 and the second substrate 2 can be suppressed. With the tensile elongation of first substrate 1 at 23 °C being 350% or less, when the sinter bonding sheet roll 10A is formed by winding the sinter bonding sheet 10B, excessive elongation of the first substrate 1 which makes it difficult to wind the sinter bonding sheet 10B can be suppressed. The first substrate 1 more preferably has a tensile elongation at 23 °C of 10% or more, further preferably has a tensile elongation at 23 °C of 30% or more, still further preferably has a tensile elongation at 23 °C of 50% or more. The first substrate 1 more preferably has a tensile elongation at 23 °C of 300% or less, further preferably has a tensile elongation at 23 °C of 200% or less, still further preferably has a tensile elongation at 23 °C of 150% or less. The tensile elongation of the first substrate 1 at 23 °C can be obtained by performing a tensile test using a tensile tester (product name "Autograph AG-X" manufactured by Shimadzu Corporation) in the conditions at a drawing speed of 300 mm/min. Specifically, a degree of elongation of the first substrate when a tensile strength reaches the breaking point in the tensile test can be obtained as the tensile elongation. The tensile test is performed by cutting the first substrate 1 to obtain a test piece having a plan dimension of a width of 1 cm and a length of 3 cm, and drawing the test piece in the length direction (i.e., length direction of the first substrate 1).

The first substrate 1 preferably has a porosity of 10% or less. The porosity of the first substrate 1 is more preferably 5% or less, further preferably 3% or less, still further preferably 1% or less. The porosity of the first substrate 1 can be 0%, can be 0.1%, can be 0.3%, or can be 0.5% or more. The porosity P of the first substrate 1 can be calculated by the following formula using an apparent density $\rho a$ of the first substrate 1 and a true density $\rho t$ of the first substrate 1.

$$P = (1-\rho a/\rho t)\times 100$$

The apparent density $\rho a$ can be determined by multiplying a surface density of the first substrate 1 by a thickness of the first substrate 1. The true density $\rho t$ can be determined by milling the first substrate 1 to obtain a poreless sample, and then measuring the density of the sample by Archimedes' principle.

The second substrate 2 and the third substrate 3 are provided for protecting, in the sinter bonding layer 5, a surface on one side facing the first substrate 1 and a surface on the opposite side, respectively. The second substrate 2 and the third substrate 3 are preferably composed of a plastic substrate in the same manner as the first substrate 1. As the plastic substrate, those described in the above description on the first substrate 1 can be used. When the semiconductor apparatus is produced using the sinter bonding sheet roll 10A as described later, the second substrate 2 and the third substrate 3 each preferably function as a release liner that allows the divided sinter bonding layer 5 (i.e., divided body 2' of the sinter bonding layer) to be easily peeled. In the case where the second substrate 2 and the third substrate 3 each function as a release liner, the surface of each of the second substrate 2 and the third substrate 3 for contact with the sinter bonding layer 5 can be applied with a repellent.

The second substrate 2 and the third substrate 3 each preferably have a thickness of 5 μm or more, more preferably have a thickness of 10 μm or more, further preferably have a thickness of 20 μm or more. The second substrate 2 and the third substrate 3 each preferably have a thickness of 1000 μm or less, more preferably have a thickness of 500 μm or less, further preferably have a thickness of 200 μm or less. The thickness of each of the second substrate 2 and the third substrate 3 can be obtained by, for example, measuring the thickness thereof at any 5 positions selected at random using a dial gauge (model R-205 manufactured by PEACOCK), followed by arithmetically averaging these thickness values.

The sinter bonding sheet roll 10A and the sinter bonding sheet 10B are not limited to those configured as shown in Fig. 1A and Fig. 1B. Specifically, the sinter bonding sheet roll 10A and the sinter bonding sheet 10B are not limited to those in which the second substrate 2, the sinter bonding layer 5, and the third substrate 3 are disposed on the first substrate 1 in this order. For example, as shown in Fig. 3A and Fig. 3B, the sinter bonding sheet roll 10A and the sinter bonding sheet 10B can have a fourth substrate 4 provided in the third substrate 3 on a surface on the opposite side to the surface facing the sinter bonding layer 5.

In the case where the sinter bonding sheet roll 10A and the sinter bonding sheet 10B are configured as shown in Fig. 3A and Fig. 3B, a longitudinal dimension $L_4$ of the fourth substrate 4 is preferably larger than any of the longitudinal dimension $L_S$ of the sinter bonding layer 5, the longitudinal dimension $L_2$ of the second substrate 2, and the longitudinal dimension $L_3$ of the third substrate 3. The longitudinal dimension $L_4$ of the fourth substrate 4 larger than the longitudinal dimension $L_S$ of the sinter bonding layer 5 allows a first winding roller 200a to wind the fourth substrate 4 with the third substrate 3 provided thereon. Thereby, the third substrate 3 can be easily wound around the first winding roller 200a, compared to the case where the sinter bonding sheet roll 10A includes only the third substrate 3. That is, a surface on one side of the sinter bonding layer 5 (i.e., a surface on the side protected by the third substrate 3) can be easily exposed. The longitudinal dimension $L_4$ of the fourth substrate 4 can be the same as or different from the dimension $L_1$ of the first substrate 1.

A surface area $S_4$ of the fourth substrate 4 in plan view is preferably larger than any of the surface area $S_S$ of the sinter bonding layer 5 in plan view, the surface area $S_2$ of the second substrate 2 in plan view, and the surface area $S_3$ of the third substrate 3 in plan view. The surface area $S_4$ of the fourth substrate 4 in plan view can be the same as or different from the surface area $S_1$ of the first substrate 1 in plan view. A width dimension $W_4$ of the fourth substrate 4 is preferably larger than any of the width dimension $W_S$ of the sinter bonding layer 5, the width dimension $W_2$ of the second substrate 2, and width dimension $W_3$ of the third substrate 3. The width dimension $W_4$ of the fourth substrate 4 can be the same as or different from the width dimension $W_1$ of the first substrate 1.

(Method for producing a semiconductor apparatus)

Next, a description will be given on an example of a method for producing a semiconductor apparatus using the sinter bonding sheet roll 10A according to this embodiment, with reference to Fig. 4A to Fig. 9B. Specifically, an example of the method for producing a semiconductor apparatus using the sinter bonding sheet roll 10A with the first substrate 1, the second substrate 2, the sinter bonding layer 5, and the third substrate 3 disposed in this order will be described.

The method for producing a semiconductor apparatus according to this embodiment is performed using a plurality of semiconductor chips, a substrate including a plurality of mounting areas on which the plurality of semiconductor chips are respectively mounted, the sinter bonding sheet roll 10A according to this embodiment, and a first pressing member configured to press the semiconductor chips to the substrate with a part of the sinter bonding layer 5 of the sinter bonding sheet roll 10A interposed therebetween to allow the plurality of semiconductor chips to be bonded to the plurality of mounting areas. In the method for producing a semiconductor apparatus according to this embodiment, the plurality of semiconductor chips are pressed in order by the first pressing member to be temporarily fixed to the plurality of mounting areas, respectively.

Hereinafter, a description will be given on a case where the substrate is a lead frame substrate, the mounting area is a die pad, and the first pressing member is a collet. Further, an example in which a part of the sinter bonding layer 5 provided in the sinter bonding sheet roll 10A is transferred to each of the plurality of semiconductor chips using a roll-to-roll machine 1000 will be hereinafter described.

First, a semiconductor wafer is cut on a dicing tape C to obtain a plurality of semiconductor chips (see Fig. 4A). Next, as shown in Fig. 4A, one semiconductor chip B1 (hereinafter also referred to as the first semiconductor chip B 1) out of the plurality of semiconductor chips is picked up by a collet A from the dicing tape C. In general, the semiconductor chip has a rectangular plate shape. More specifically, the semiconductor chip has a square plate shape. A thickness of the semiconductor chip is, for example, 10 μm or more and 500 μm or less. The thickness of the semiconductor chip is preferably 20 μm or more and 400 μm or less. An area of the semiconductor chip in plan view is, for example, 0.01 $mm^2$ or more and 1000 $mm^2$ or less. The area of the semiconductor chip in plan view is preferably 0.04 $mm^2$ or more and 500 $mm^2$ or less. A plane size of the collet A on the side in contact with the semiconductor chip corresponds to the size of the chip size. That is, an area S 1a (hereinafter also referred to as the collet area S1a) of the collet A on the side in contact with the

semiconductor chip corresponds in plan view to an area S2a (hereinafter also referred to as the chip area S2a) of the semiconductor chip in plan view. More specifically, the collet area S 1a is 0.9 times or more and 1.1 times or less as large as the chip area S2a.

Next, using the roll-to-roll machine 1000, a part of the sinter bonding layer 5 of the sinter bonding sheet roll 10A is transferred to the first semiconductor chip B1.

As shown in Fig. 5, the roll-to-roll machine 1000 includes the feed roller 100, the transfer stage G disposed on the downstream side of the feed roller 100, and a pair of a first winding roller 200a and a second winding roller 200b disposed on the downstream side of the transfer stage G. Here, as shown in Fig. 1A, the sinter bonding sheet roll 10A according to this embodiment includes the first substrate 1, the second substrate 2 laminated on the first substrate 1, the sinter bonding layer 5 laminated on the second substrate 2, and the third substrate 3 laminated on the sinter bonding layer 5. That is, the sinter bonding sheet roll 10A according to this embodiment has a four-layer structure in which the first substrate 1, the second substrate 2, the sinter bonding layer 5, and the third substrate 3 are laminated in this order. The third substrate 3 peeled from one surface of the sinter bonding layer 5 is wound around the first winding roller 200a in order to allow the sinter bonding layer 5 to have an exposed surface for contacting with each of the plurality of semiconductor chips. A sheet body after a part of the sinter bonding layer 5 is transferred to each of the plurality of semiconductor chips is wound around the second winding roller 200b. The sheet body after the transferring means a sheet laminated body in which the first substrate 1, the second substrate 2, and the rest of the sinter bonding layer 5 are laminated in this order.

The roll-to-roll machine 1000 includes the first conveying roller 101, the second conveying roller 102, and the third conveying roller 103 disposed in this order from the upstream side toward the downstream side between the feed roller 100 and the transfer stage G, for conveying the sinter bonding sheet roll 10A, fed from the feed roller 100, toward the transfer stage G. The roll-to-roll machine 1000 further includes, between the transfer stage G and the second winding roller 200b, the fourth conveying roller 104 for conveying the sheet body after the transferring from the transfer stage G toward the second winding roller 200b. The roll-to-roll machine 1000 further includes a fifth conveying roller 105 and a sixth conveying roller 106 disposed in this order from the upstream side toward the downstream side between the second conveying roller 102 and the first winding roller 200a for conveying the third substrate 3 to be wound by the first winding roller 200a. The first conveying roller 101 to the sixth conveying roller 106 apply tension to the sheet body being conveyed.

The band-shaped sinter bonding sheet 10B fed from the sinter bonding sheet roll 10A is conveyed by the first conveying roller 101 and the second conveying roller 102. The sheet body before the transferring, in which one surface of the sinter bonding layer 5 is exposed by the peeling of the third substrate 3, is conveyed by the third conveying roller 103. The sheet body after the transferring is conveyed by the fourth conveying roller 104, as described, and the third substrate 3 is conveyed by the fifth conveying roller 105 and the sixth conveying roller 106. The first conveying roller 101 to the sixth conveying roller 106 are stopped during the transferring of a part of the sinter bonding layer 5 to each of the plurality of semiconductor chips on the transfer stage G. That is, the transferring of a part of the sinter bonding layer 5 to each of the plurality of semiconductor chips is performed on the transfer stage G with the sinter bonding layer 5 allowed to stand still.

Specifically, the transferring of a part of the sinter bonding layer 5 to the first semiconductor chip B1 is performed by pressing the first semiconductor chip B1 to the sinter bonding layer 5 by the collet A, with the sinter bonding layer allowed to stand still, as shown in Fig. 6A. Thereby, the first semiconductor chip B1 with the divided body of the sinter bonding layer 5 (hereinafter also referred to as the divided body 2' of the sinter bonding layer') can be obtained. As shown in Fig. 6A, it is preferable that the transferring of a part of the sinter bonding layer 5 to the first semiconductor chip B1 be performed with the cushion member CM interposed between the first substrate 1 and the transfer stage G. That is, it is preferable that the transferring of a part of the sinter bonding layer 5 to the first semiconductor chip B1 be performed in the state where the cushion member CM, the first substrate 1, and the sinter bonding layer 5 are allowed to stand still in this order on the transfer stage G. Disposing the first substrate 1 on the cushion member CM in this way enables sufficient suppression of occurrence of a repulsive force to the first substrate 1 due to the pressing, when the first semiconductor chip B1 or the second semiconductor chip B2 is pressed to the sinter bonding layer 5 using the collet A. As a result, a part of the sinter bonding layer 5 can be further sufficiently transferred to the first semiconductor chip B1 or the second semiconductor chip B2. As the cushion member CM, a film composed of silicone rubber, fluoro rubber, a fluoro resin, or porous polyethylene can be used. Examples of the fluororubber include binary fluoro rubber and ternary fluoro rubber. Examples of the binary fluoro rubber include a copolymer of vinylidene fluoride (VDF) and hexafluoropropylene (HFP). Examples of the ternary fluoro rubber include a copolymer of vinylidene fluoride (VDF), hexafluoropropylene (HFP) and tetrafluoroethylene (TFE), and a copolymer of vinylidene fluoride (VDF), perfluoromethylvinyl ether (PMVE) and tetrafluoroethylene (TFE). Examples of the fluoro resin include polytetrafluoroethylene (PTFE). The pressure for pressing the first semiconductor chip B1 onto the sinter bonding layer 5 is preferably 0.01 MPa or more and 10 MPa or less, more preferably 0.1 MPa or more and 5 MPa or less. The temperature of the collet A or the transfer stage G when the first semiconductor chip B1 is pressed onto the sinter bonding layer 5 is preferably 40 °C or more and 150 °C or less, more preferably 50 °C or more and 130 °C or less. The temperature of the collet A or the transfer stage G within the above range allows a part of the sinter bonding layer 5 to be pressed and cut, to thereby allow the divided body 2' of the sinter bonding layer to be appropriately transferred to the first semiconductor chip B1.

Next, as shown in Fig. 7A, the first semiconductor chip B1 with the divided body 2' of the sinter bonding layer is picked up by the collet A.

Next, as shown in Fig. 8A, a lead frame substrate D is mounted on a stage H. Next, the collet A that is kept at a temperature in the range between 25 °C and 100 °C is moved vertically downward to allow the divided body 2' of the sinter bonding layer in the first semiconductor chip B 1 to come into contact with a first die pad E1 in the lead frame substrate D. Then, the first semiconductor chip B1 with the divided body 2' of the sinter bonding layer is pressed (i.e., applied with pressure) by the collet A. Specifically, pressure is applied to the first semiconductor chip B 1 by the collet A to attach the divided body 2' of the sinter bonding layer to the first die pad E1 of the lead frame substrate D. Thereby, the first semiconductor chip B 1 is temporarily fixed to the first die pad E1 of the lead frame substrate D via the divided body 2' of the sinter bonding layer (see Fig. 8A). The pressure when the first semiconductor chip B 1 with the divided body 2' of the sinter bonding layer is pressed onto the first die pad E1 of the lead frame substrate D from the side of the divided body 2' of the sinter bonding layer is preferably 0.01 MPa or more and 50 MPa or less, more preferably 0.1 MPa or more and 30 MPa or less.

After the first semiconductor chip B 1 is temporarily fixed to the first die pad E1 of the lead frame substrate D as described above, another semiconductor chip B2 (hereinafter also referred to as the second semiconductor chip B2) out of the plurality of semiconductor chips is picked up from the dicing tape C by the collet A as shown in Fig. 4B.

Next, as shown in Fig. 6B, the second semiconductor chip B2 is pressed onto the sinter bonding layer 5 of the sinter bonding sheet roll 10A (10B) by the collet A to transfer a part of the sinter bonding layer 5 to the second semiconductor chip B2. Thereby, the second semiconductor chip B2 with the divided body 2' of the sinter bonding layer can be obtained.

Next, as shown in Fig. 7B, the second semiconductor chip B2 with the divided body 2' of the sinter bonding layer is picked up from the sinter bonding sheet 10 by the collet A. Next, with the collet A kept at a temperature in the range between 25 °C and 150 °C, the second semiconductor chip B2 with the divided body 2' of the sinter bonding layer is allowed to come into contact with the other die pad E2 (i.e., second die pad E2) in the lead frame substrate D from the side of the divided body 2' of the sinter bonding layer. Then, the second semiconductor chip B2 with the divided body 2' of the sinter bonding layer is pressed (i.e., applied with pressure) by the collet A. Thereby, the second semiconductor chip B2 is temporarily fixed to the second die pad E2 of the lead frame substrate D via the divided body 2' of the sinter bonding layer (see Fig. 8B). The aforementioned steps are subsequently repeated until the semiconductor chips are respectively mounted on all of the die pads of the lead frame substrate D.

After, for example, the first semiconductor chip B 1 is temporarily fixed to the first die pad E1 of the lead frame substrate D or the second semiconductor chip B2 is temporarily fixed to the second die pad E2 of the lead frame substrate D, it can be configured such that the collet A is heated to a temperature at which the sinterable metal particles (i.e., the sinterable metal particles included in the divided body 2' of the sinter bonding layer) can be sintered, and thereby the sinterable metal particles in the divided body 2' of the sinter bonding layer are subjected to a primary sintering. That is, when there is a semiconductor chip in addition to the first semiconductor chip B1 and the second semiconductor chip B2 as the semiconductor chip to be temporarily fixed to the die pad of the lead frame substrate D, the primary sintering can be performed on the sinterable particles included in the divided body 2' of the sinter bonding layer used for temporarily fixing the other semiconductor chip to the die pad.

When the sinterable particles included in the divided body 2' of the sinter bonding layer are sinterable particles that can be sintered at a heating temperature of 400 °C or less, the collet A is preferably heated at a temperature of 200 °C or more. Since the collet A heated to a temperature of 200 °C or more allows the sinterable particles to be more sufficiently sintered to each other, the semiconductor chips can be more firmly mounted on the die pads of the lead frame substrate D with the divided body 2' of the sinter bonding layer interposed therebetween. That is, the connection reliability of a semiconductor chip such as the first semiconductor chip B 1 or the second semiconductor chip B2 to a substrate such as the lead frame substrate D can be improved.

When the primary sintering is performed, it is preferable that the collet A be rapidly heated (in about 5 seconds) to a temperature at which the sinterable particles can be sintered. The collet A is heated to a temperature at which the sinterable particles can be sintered at a heating rate of preferably 30 °C/sec or more, more preferably 45 °C/sec or more. The primary sintering can be performed by heating the stage H, in addition to heating of the collet A, to a temperature equal to or higher than the temperature at which the sinterable particles can be sintered. Thereby, the heating can be performed from both sides of the divided body 2' of the sinter bonding layer so that the sinterable particles can be further sufficiently sintered to each other in the divided body 2' of the sinter bonding layer. As a result, the semiconductor chips can be further firmly mounted on the die pads of the lead frame substrate D, respectively, with the divided body 2' of the sinter bonding layer interposed therebetween. That is, the connection reliability of a semiconductor chip such as the first semiconductor chip B 1 or the second semiconductor chip B2 to a substrate such as the lead frame substrate D can be further improved. The temperature for heating the stage H is preferably equal to or lower than the temperature at which the lead frame substrate D is suppressed from being oxidized. For example, in the case where the lead frame substrate D is composed of a Cu alloy (e.g., Cu-Cr-Zr, Cu-Cr-Sn-Zn, and Cu-Ni-Si-Mg), the temperature for heating the stage H is preferably 150 °C or

less.

After the first sintering is performed on the divided body 2' of the sinter bonding layer, it is preferable that the collet A be pulled upward to be separated from the semiconductor chip with the divided body 2' of the sinter bonding layer to lower the temperature of the collet A to a temperature at which the sinterable particles are barely sintered (for example, 50 °C).

When the primary sintering is performed on each of the divided bodies 2' of the sinter bonding layer at the time of mounting the semiconductor chips to all of the die pads of the lead frame substrate D, a bonding wire can be applied to a required part.

The method for producing a semiconductor apparatus according to this embodiment can include, after the plurality of semiconductor chips are pressed in order to be temporarily fixed to the plurality of mounting areas, a heating step of heating the substrate with the plurality of semiconductor chips mounted thereon at a temperature at which the sinterable particles can be sintered. In the aforementioned heating step, the aforementioned heating can be performed, while pressing the part or all of the plurality of semiconductor chips onto the substrate. In the aforementioned heating step, the pressing can be performed, while pressing none of the plurality of semiconductor chips onto the substrate. The aforementioned heating step is provided as a secondary heating step when heating (i.e., primary heating) is performed in order to primarily sintering the sinterable particles included in the divided body 2' of the sinter bonding layer.

More specifically, it can be configured such that the stage H is heated (i.e., the heating step is performed) to the temperature (for example, any temperature within the range between 200 °C and 400 °C) at which the sinterable particles included in the divided body 2' of the sinter bonding layer can be sintered, in the state where, as shown in Fig. 9A, a part or all of the semiconductor chips mounted on all of the die pads of the lead frame substrate D are not being pressed after the semiconductor chips are temporarily fixed to all of the die pads of the lead frame substrate D. Fig. 9A shows an example of a heating operation which is performed while pressing noneof the semiconductor chips (i.e., the first semiconductor chip B1 and the second semiconductor chip B2) mounted on all of the die pads (i.e., the first die pad E1 and the second die pad E2) of the lead frame substrate D. With the heating step performed in this way, the sinterable particles can be sintered to each other, and thus the semiconductor chips can be firmly mounted on the substrate (i.e., lead frame substrate D) with the divided bodies 2' of the sinter bonding layer interposed therebetween. That is, the connection reliability of the semiconductor chips to the substrate can be improved. Further, a facility for use in the heating step can have a simplified configuration with no pressing member for pressing a part or all of the plurality of semiconductor chips. Also in the case where the aforementioned heating step is performed, a bonding wire can be applied at a part required after the heating step.

The method for producing a semiconductor apparatus according to this embodiment can be configured such that, in the heating step of heating at a temperature at which the sinterable particles can be sintered, the heating is performed while pressing a part or all of the plurality of semiconductor chips onto the substrate. Further, in the method for producing a semiconductor apparatus according to this embodiment, the heating step can be configured such that the aforementioned heating is performed while pressing all of the plurality of semiconductor chips onto the substrate.

More specifically, a heating and pressing device F that is configured to be able to apply heat and includes two flat plates (i.e., parallel flat plates) disposed to, after the semiconductor chips are temporarily fixed to all of the die pads of the lead frame substrate D, sandwich a part or all of the semiconductor chips mounted on all of the die pads of the lead frame substrate D from above and below, as shown in Fig. 9B, is used. It can be configured such that the heating and pressing device F heats a part or all of the semiconductor chips mounted on all of the die pads of the lead frame substrate D at a temperature at which the sinterable particles can be sintered, while pressing (i.e., applying a pressure to) the part or all of the semiconductor chips. Fig. 9B shows an example of a heating operation which is performed while pressing all of the semiconductor chips (i.e., the first semiconductor chip B1 and the second semiconductor chip B2) mounted on all of the die pads of the lead frame substrate D (i.e., the first die pad E1 and the second die pad E2). The heating step performed in this way enables to perform the heating while pressing a part or all of the plurality of semiconductor chips onto the substrate (i.e., lead frame substrate D), and thus a part or all of the plurality of semiconductor chips can be firmly mounted on the substrate (i.e., lead frame substrate D) with the divided body 2' of the sinter bonding layer interposed therebetween. That is, the connection reliability of the semiconductor chips to the substrate can be improved. Also in the case where the aforementioned heating step is performed, a bonding wire can be applied at a required part after the heating step.

Various types of known lead frame substrates can be adopted as the lead frame substrate D. Examples of the various types of known lead frame substrates include a lead frame substrate formed of a Cu lead frame substrate subjected to Ag plating, and a lead frame substrate (e.g., Palladium Pre Plated Lead Frame. Pd-PPF) formed by plating a Cu lead frame substrate with Ni, Pd, and Au in this order.

Matters disclosed herein by the present application include the following matters.

(1) A sinter bonding sheet roll including a first substrate and a sinter bonding layer laminated on the first substrate, and formed by winding, in a length direction, a sinter bonding sheet that is formed into a band shape, in which

the sinter bonding layer includes sinterable particles containing a conductive metal, and an organic binder, and is

directly laminated on the first substrate or is indirectly laminated on the first substrate via a second substrate interposed therebetween, and

a longitudinal dimension $L_1$ of the first substrate is larger than any of a longitudinal dimension $L_S$ of the sinter bonding layer and a longitudinal dimension $L_2$ of the second substrate.

The sinter bonding sheet roll having the above configuration can suppress the reduction in the yield rate in producing the semiconductor apparatus.

(2) The sinter bonding sheet roll described in the above (1), further including a third substrate disposed on a surface of the sinter bonding layer which is on an opposite side to a surface facing the first substrate, in which
the longitudinal dimension $L_1$ of the first substrate is larger than a longitudinal dimension $L_3$ of the third substrate.
(3) The sinter bonding sheet roll described in the above (1) or (2), in which
the sinter bonding layer and the second substrate are laminated on the first substrate continuously or intermittently in the length direction.
(4) The sinter bonding sheet roll described in any one of the above (1) to (3), in which
a surface area $S_1$ of the first substrate in plan view is larger than any of a surface area $S_S$ of the sinter bonding layer in plan view and a surface area $S_2$ of the second substrate in plan view.
(5) The sinter bonding sheet roll described in any one of the above (2) to (4), in which
the surface area $S_1$ of the first substrate in plan view is larger than a surface area $S_3$ of the third substrate in plan view.
(6) The sinter bonding sheet roll described in any one of the above (1) to (5), in which
a width dimension $W_1$ of the first substrate is larger than any of a width dimension $W_S$ of the sinter bonding layer and a width dimension $W_2$ of the second substrate.
(7) The sinter bonding sheet roll described in any one of the above (2) to (6), in which
the width dimension $W_1$ of the first substrate is larger than the width dimension $W_3$ of the third substrate.
(8) The sinter bonding sheet roll described in the above (2), further including a fourth substrate disposed on a surface of the third substrate which is on an opposite side to a surface facing the sinter bonding layer, in which
a longitudinal dimension $L_4$ of the fourth substrate is larger than any of the longitudinal dimension $L_S$ of the sinter bonding layer, the longitudinal dimension $L_2$ of the second substrate, and the longitudinal dimension $L_3$ of the third substrate.
(9) The sinter bonding sheet roll described in the above (8), in which
a surface area $S_4$ of the fourth substrate in plan view is larger than any of the surface area $S_S$ of the sinter bonding layer in plan view, the surface area $S_2$ of the second substrate in plan view, and the surface area $S_3$ of the third substrate in plan view.
(10) The sinter bonding sheet roll described in the above (8) or (9), in which
a width dimension $W_4$ of the fourth substrate is larger than any of the width dimension $W_S$ of the sinter bonding layer, the width dimension $W_2$ of the second substrate, and width dimension $W_3$ of the third substrate.
(11) The sinter bonding sheet roll described in any one of the above (1) to (10), in which
the first substrate has a thickness of 30 μm or more and 150 μm or less.
(12) The sinter bonding sheet roll described in any one of the above (1) to (11), in which

the first substrate has a contact surface for contacting with the sinter bonding layer or the second substrate, and a Young's modulus at 23 °C obtained by measuring the contact surface using a nano-indentation method is 0.5 GPa or more and 5.0 GPa or less.

(13) The sinter bonding sheet roll described in any one of the above (1) to (12), in which
the first substrate has a tensile elongation at 23 °C of 4% or more and 350% or less.
(14) The sinter bonding sheet roll described in any one of the above (1) to (13), in which
the first substrate has a porosity of 10% or less.

The sinter bonding sheet roll according to the present invention is not limited to the aforementioned embodiment. The sinter bonding sheet roll according to the present invention is not limited by the aforementioned operational advantages, either. Various modifications can be made for the sinter bonding sheet roll according to the present invention without departing from the gist of the present invention.

EXAMPLES

Hereinafter, the present invention will be more specifically described with reference to Examples and Comparative Examples. The following examples are provided for more specifically describing the present invention, and do not intend to limit the scope of the present invention.

(Example 1A)

First silver particles (average particle size: 60 nm; manufactured by DOWA Electronics Materials Co., Ltd.), second silver particles (average particle size: 1100 nm; manufactured by Mitsui Mining & Smelting Co., Ltd.), a polycarbonate resin (product name "QPAC40"; manufactured by Empower Materials, Inc.), and isobornyl cyclohexanol (product name "Terusolve MTPH" manufactured by NIPPON TERPENE CHEMICALS, INC.) were dissolved or suspended in methyl ethyl ketone (MEK) at a blending ratio (i.e., blending ratio for the sinter bonding layer) shown in Table 1 below, to prepare a varnish. Stirring and mixing of the above components were performed using a hybrid mixer (model: "HM-500"; manufactured by KEYENCE CORPORATION) in the stirring mode for 3 minutes to allow these components to be dissolved or suspended in methyl ethyl ketone. The varnish was applied at a thickness of 200 μm to a release-treated surface of a second substrate (release-treated film: product name: "MRA38" manufactured by Mitsubishi Chemical Corporation) to form a coating layer, followed by heating the coating layer at a temperature of 110 °C for 3 minutes to form a sinter bonding layer on the second substrate. Thereby, a release-treated film with a sinter bonding layer was obtained. The second substrate has a plane dimension with a length of 80000 mm (80m) × a width of 130 mm (13 cm), and the coating layer was formed on the entire area of the release-treated surface of the second substrate. That is, the sinter bonding layer and the second substrate have the same plane dimension.

Next, the third substrate (release-treated film: product name "MRA38" manufactured by Mitsubishi Chemical Corporation) was placed on the sinter bonding layer of the release-treated film with the sinter bonding layer to obtain a laminated body with the second substrate, the sinter bonding layer, and the third substrate laminated in this order. The plane dimension of the third substrate was also the same as the second substrate and the sinter bonding layer. Next, the laminated body was placed on a PET substrate (product name "E-MASK (registered trademark) CP170" manufactured by Nitto Denko Corporation) as the first substrate to obtain a band-shaped sinter bonding sheet according to Example 1. That is, the sinter bonding sheet according to Example 1 was a four-layer laminated body, in which the first substrate, the second substrate, the sinter bonding layer, and the third substrate were laminated in this order. The PET substrate as the first substrate had a plane dimension with a length of 100000 mm (100 m) and a width of 150 mm (15 cm), which was larger than any of the plane dimension of the second substrate, the plane dimension of the sinter bonding layer, and the plane dimension of the third substrate. Further, the laminated body was placed on the first substrate so as to have a central portion of the laminated body and a central portion of the first substrate overlapping with each other in the thickness direction. Since the PET substrate as the first substrate has an adhesive layer including an acrylic resin on its surface on one side, the laminated body was held on the PET substrate as the first substrate by the adhesive layer. The first silver particles and the second silver particles are categorized as the sinterable particles, the polycarbonate resin is categorized as the first organic binder (i.e., thermally-degradable high molecular binder), and isobornyl cyclohexanol is categorized as the second organic binder (i.e., low boiling point binder). In Table 1 below, a blending amount of the sinterable particles is represented by a value of ash, and a blending amount of each of the first silver particles and the second silver particles is represented by an amount in blending.

(Example 2)

A band-shaped sinter bonding sheet according to Example 2 was obtained in the same manner as Example 1 except that the first substrate was replaced with a first PE substrate (product name "E-MASK (registered trademark) R200" manufactured by Nitto Denko Corporation). Since the first PE substrate as the first substrate has an adhesive layer including an acrylic resin on its surface on one side, the laminated body according to Example 2 was held on the first PE substrate as the first substrate by the adhesive layer.

(Example 3)

A band-shaped sinter bonding sheet according to Example 3 was obtained in the same manner as Example 1 except that the first substrate was replaced with a PI substrate (product name "TRM-6250L" manufactured by Nitto Denko Corporation). Since the PI substrate as the first substrate has an adhesive layer including an acrylic resin on its surface on one side, the laminated body according to Example 3 was held on the PI substrate as the first substrate by the adhesive layer.

(Example 4)

A band-shaped sinter bonding sheet according to Example 4 was obtained in the same manner as Example 1 except that the first substrate was replaced with a second PE substrate (product name "SUNMAP LC-T5320T" manufactured by Nitto Denko Corporation). As described above, SUNMAP LC-T5320T is a porous plastic substrate having a porosity of 30%. Since the second PE substrate as the first substrate has an adhesive layer including an acrylic

resin and a urethane resin on its surface on one side, the laminated body according to Example 4 was held on the second PE substrate as the first substrate by the adhesive layer.

(Example 5)

A band-shaped sinter bonding sheet according to Example 5 was obtained in the same manner as Example 1 except that the first substrate was replaced with a PTFE substrate (product name "NIFTRON (registered trademark) 9030UL" manufactured by Nitto Denko Corporation) having a thickness of 230 μm. Since the PTFE substrate having a thickness of 230 μm as the first substrate has an adhesive layer including a silicone resin on its surface on one side, the laminated body according to Example 5 was held on the PTFE substrate having a thickness of 230 μm as the first substrate by the adhesive layer.

(Example 6)

A band-shaped sinter bonding sheet according to Example 6 was obtained in the same manner as Example 1 except that the first substrate was replaced with a PTFE substrate (product name "NIFTRON (registered trademark) 9030UL" manufactured by Nitto Denko Corporation) having a thickness of 80 μm. Since the PTFE substrate having a thickness of 80 μm as the first substrate has an adhesive layer including a silicone resin on its surface on one side, the laminated body according to Example 6 was held on the PTFE substrate having a thickness of 80 μm as the first substrate by the adhesive layer.

(Comparative Example 1)

A band-shaped sinter bonding sheet according to Comparative Example 1 was obtained in the same manner as Example 1 except that the first substrate was not used. That is, the sinter bonding sheet according to Comparative Example 1 was a three-layer laminated body, in which the second substrate (release-treated film: product name: "MRA38" manufactured by Mitsubishi Chemical Corporation), the sinter bonding layer, and the third substrate (release-treated film: product name: "MRA38" manufactured by Mitsubishi Chemical Corporation) were laminated in this order.

As to the sinter bonding sheet according to each of the Examples, Table 2 below shows the measurement results of the thickness of the first substrate, the measurement results of the Young's modulus at 23 °C of the first substrate, and the measurement results of the tensile elongation of the first substrate. The thickness of the first substrate, the Young's modulus at 23 °C of the first substrate, and the tensile elongation of the first substrate were measured according to the methods described in the above description on the embodiments.

Table 1

| | | Parts by mass | | mass% |
|---|---|---|---|---|
| Sinter bonding layer | Sinterable particles | 93 | First silver particles | 90 |
| | | | Second silver particles | 10 |
| | Organic binder | 7 | Polypropyrene carbonate | 20 |
| | | | Isobornyl cyclohexanol | 80 |

< Production yield of sinter bonding layer >

For the sinter bonding sheet according to each of the Examples and Comparative Examples, the production yield of the sinter bonding layer was evaluated. Specifically, evaluation was performed with the roll-to-roll machine 1000 as shown in Fig. 5 by calculating the ratio of surface area of the sinter bonding layer usable at the transfer stage G during the conveyance of the sinter bonding sheet roll, obtained by winding the sinter bonding sheet according to each of the Examples and Comparative Examples, from the feed roller 100 toward the second winding roller 200b. That is, evaluation was performed by calculating the ratio ($[S_U/S_T]\times100$) of a surface area ($S_U$) of the sinter bonding layer usable at the transfer stage G relative to the total surface area ($S_T$) of the sinter bonding layer. The results indicate that the higher the values of the aforementioned ratio, the more the reduction in the production yield can be suppressed. The ratio ($[S_U/S_T]\times100$) was calculated based on the conditions that a distance between a shaft of the feed roller 100 and one end in the length direction of the transfer stage G facing (closest to) the shaft is 2 m, and a distance between a shaft of the second winding roller 200b and another end in the length direction of the transfer stage G facing (closest to) the shaft is 2 m. Further, the ratio ($[S_U/S_T]\times100$) was calculated on the assumption that the sinter bonding sheet was held at each of both

end portions in the width direction by 5 mm in width using a jig on the transfer stage G. Note that a sufficient thickness could not be secured at the both end portions in the length direction of the sinter bonding layer. Thus, even in the case where the total surface area of the sinter bonding layer was usable in the transfer stage G, the aforementioned ratio was calculated excluding the areas of these both end portions where the sufficient thickness could not been secured. Table 2 below shows the calculation results.

< Evaluation of transfer properties >

For the sinter bonding sheet according to each of the Examples and Comparative Examples, the transfer properties of the sinter bonding layer to an Si chip were evaluated. The transfer properties of the sinter bonding layer to the Si chip were evaluated using a flip chip bonder (FC3000W manufactured by Toray Engineering Co., Ltd.).

The transfer properties were evaluated with the following procedure.

(1) For the sinter bonding sheet according to each of the Examples and Comparative Examples, a release-treated film as the third substrate is peeled to obtain an adhesive surface.

(2) A cushion member (product name "FF10N" manufactured by Yamauchi Corporation) is mounted on a stage provided in the flip chip bonder, and then, the sinter bonding sheet according to each of the Examples and Comparative Examples is mounted on the cushion member to allow the first substrate to be in contact with the cushion member. That is, the sinter bonding sheet according to each of the Examples and Comparative Examples is mounted on the cushion member so as to expose the adhesive surface.

(3) Using a collet heated at 100 °C, an Si chip (with a 5 mm square and a thickness of 200 μm) having an entirely silver-coated surface on one side is pressed onto the adhesive surface of the sinter bonding sheet according to each of the Examples and Comparative Examples at a load of 12.5 N for 1 second. Here, the silver-coated surface on one side in the Si chip is pressed onto the adhesive surface.

(4) By lifting up the collet at a speed of 0.3 mm/sec., a part of the sinter bonding layer of the sinter bonding sheet according to each of the Examples and Comparative Examples is allowed to be transferred to one surface of the Si chip. Then, visual observation is made on the transferred size of the sinter bonding layer to evaluate the transfer properties based on the following criteria.

◦: The sinter bonding layer is transferred with the same size as the Si chips every time when the transferring is made a certain number of times.

△: The sinter bonding layer is not transferred with the same size as the Si chips sometimes when the transferring is made a certain number of times.

×: There is a practical problem because the sinter bonding layer is often not transferred with the same size as the Si chips when the transferring is made a certain number of times.

(5) The above steps (1) to (4) are repeated a certain number of times (10 times). Table 2 below shows the evaluation results of the transfer properties.

< Evaluation on formation of burrs >

For the sinter bonding sheet according to each of the Examples and Comparative Examples, the formation of burrs was evaluated. The formation of burrs was evaluated by capturing an image of the Si chip, to which the sinter bonding layer has been transferred, by a digital microscope (product name "VHX-2000" manufactured by KEYENCE CORPORATION) and observing a captured image. The image of the surface on the other side (i.e., the side of the surface not subjected to silver coating) of the Si chip was captured by the digital microscope. The following conditions were adopted for the capturing by the digital microscope.

· Lens: Z20 set at 100 times magnification
· Shutter speed: 1/60 sec
· Gain: 0 db
· Lighting: Lamp ON (ca. 90%), Stage transmitted illumination ON (ca. 20%)
· Frame rate: 15 F/sec

The formation of burrs was evaluated with the following criteria.

◦: A portion of the sinter bonding layer protruded from the peripheral edge of the Si chip is less than 100 μm.

×: A portion of the sinter bonding layer protruded from the peripheral edge of the Si chip is 100 μm or more.

Table 2 shows the evaluation results of the formation of burrs.

Table 2

| | Ex. 1 | Ex. 2 | Ex. 3 | Ex. 4 |
|---|---|---|---|---|
| First substrate | PET substrate | First PE substrate | PI substrate | Second PE substrate |
| Second substrate | First PET release liner | First PET release liner | First PET release liner | First PET release liner |
| Third substrate | First PET release liner | First PET release liner | First PET release liner | First PET release liner |
| Thickness of first substrate [μm] | 145 | 65 | 31 | 220 |
| Young's modulus of first substrate [Gpa] | 3.4 | 0.9 | 3.5 | 0.3 |
| Tensile elongation of first substrate [%] | 100 | 350 | 4 | 90 |
| Yield rate of sinter bonding layer [%] | Over 99 | Over 99 | Over 99 | Over 99 |
| Transfer properties | ○ | ○ | Δ | × |
| Generation of burrs | ○ | ○ | ○ | ○ |
| | Ex. 5 | Ex. 6 | C. EX. 1 | |
| First substrate | PTFE substrate | PTFE substrate | Nil | |
| Second substrate | First PET release liner | First PET release liner | First PET release liner | |
| Third substrate | First PET release liner | First PET release liner | First PET release liner | |
| Thickness of first substrate [μm] | 230 | 80 | - | |
| Young's modulus of first substrate [Gpa] | 0.5 | 0.5 | - | |
| Tensile elongation of first substrate [%] | 220 | 180 | - | |
| Yield rate of sinter bonding layer [%] | Over 99 | Over 99 | 48~82 | |
| Transfer properties | × | Δ | ○ | |
| Generation of burrs | × | ○ | ○ | |

As can be seen from Table 2, in each of the sinter bonding sheets according to the Examples, the production yield of the sinter bonding layer exceeds 99%, and the sinter bonding layer can be almost entirely used. Contrarily, in the sinter bonding sheet according to Comparative Example 1, the production yield of the sinter bonding layer falls within the range between 48 to 82%, and the sinter bonding layer cannot be used effectively. This reveals that the sinter bonding sheet according to each of the Examples can suppress the reduction in the production yield when the sinter bonding sheet is attached to the roll-to-roll machine for use as a sheet roll. Further, as can be seen from Table 2, the sinter bonding sheet according to Example 1 and Example 2 are excellent in both of the evaluation of the transfer properties and the evaluation of the formation of burrs.

REFERENCE SIGNS LIST

1: First substrate
2: Second substrate
3: Third substrate
4: Fourth substrate
5: Sinter bonding layer
10A: Sinter bonding sheet roll
10B: Sinter bonding sheet

## Claims

1. A sinter bonding sheet roll comprising a first substrate and a sinter bonding layer laminated on the first substrate, and formed by winding, in a length direction, a sinter bonding sheet that is formed into a band shape, wherein

    the sinter bonding layer comprises sinterable particles containing a conductive metal, and an organic binder, and is directly laminated on the first substrate or is indirectly laminated on the first substrate via a second substrate interposed therebetween, and
    a longitudinal dimension $L_1$ of the first substrate is larger than any of a longitudinal dimension $L_S$ of the sinter bonding layer and a longitudinal dimension $L_2$ of the second substrate.

2. The sinter bonding sheet roll according to claim 1, further comprising a third substrate disposed on a surface of the sinter bonding layer which is on an opposite side to a surface facing the first substrate, wherein
the longitudinal dimension $L_1$ of the first substrate is larger than a longitudinal dimension $L_3$ of the third substrate.

3. The sinter bonding sheet roll according to claim 1 or 2, wherein
the sinter bonding layer and the second substrate are laminated on the first substrate continuously or intermittently in the length direction.

4. The sinter bonding sheet roll according to any one of claims 1 to 3, wherein
a surface area $S_1$ of the first substrate in plan view is larger than any of a surface area $S_S$ of the sinter bonding layer in plan view and a surface area $S_2$ of the second substrate in plan view.

5. The sinter bonding sheet roll according to claim 2, wherein
the surface area $S_1$ of the first substrate in plan view is larger than a surface area $S_3$ of the third substrate in plan view.

6. The sinter bonding sheet roll according to claim 1, wherein
a width dimension $W_1$ of the first substrate is larger than any of a width dimension $W_S$ of the sinter bonding layer and a width dimension $W_2$ of the second substrate.

7. The sinter bonding sheet roll according to claim 2, wherein
the width dimension $W_1$ of the first substrate is larger than the width dimension $W_3$ of the third substrate.

8. The sinter bonding sheet roll according to claim 2, further comprising a fourth substrate disposed on a surface of the third substrate which is on an opposite side to a surface facing the sinter bonding layer, wherein
a longitudinal dimension $L_4$ of the fourth substrate is larger than any of the longitudinal dimension $L_S$ of the sinter bonding layer, the longitudinal dimension $L_2$ of the second substrate, and the longitudinal dimension $L_3$ of the third substrate.

9. The sinter bonding sheet roll according to claim 8, wherein
a surface area $S_4$ of the fourth substrate in plan view is larger than any of the surface area $S_S$ of the sinter bonding layer in plan view, the surface area $S_2$ of the second substrate in plan view, and the surface area $S_3$ of the third substrate in plan view.

10. The sinter bonding sheet roll according to claim 8 or 9, wherein
a width dimension $W_4$ of the fourth substrate is larger than any of the width dimension $W_S$ of the sinter bonding layer, the width dimension $W_2$ of the second substrate, and the width dimension $W_3$ of the third substrate.

11. The sinter bonding sheet roll according to any one of claims 1 to 3, wherein

the first substrate has a thickness of 30 μm or more and 150 μm or less.

**12.** The sinter bonding sheet roll according to any one of claims 1 to 3, wherein

the first substrate has a contact surface for contacting with the sinter bonding layer or the second substrate, and a Young's modulus at 23 °C obtained by measuring the contact surface using a nano-indentation method is 0.5 GPa or more and 5.0 GPa or less.

**13.** The sinter bonding sheet roll according to any one of claims 1 to 3, wherein
the first substrate has a tensile elongation at 23 °C of 4% or more and 350% or less.

**14.** The sinter bonding sheet roll according to any one of claims 1 to 3, wherein
the first substrate has a porosity of 10% or less.

Ｆｉｇ．１Ａ

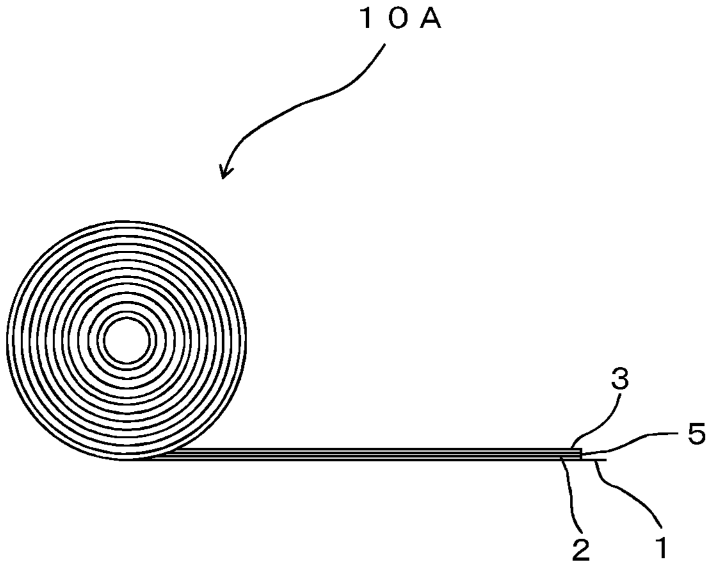


Ｆｉｇ．１Ｂ

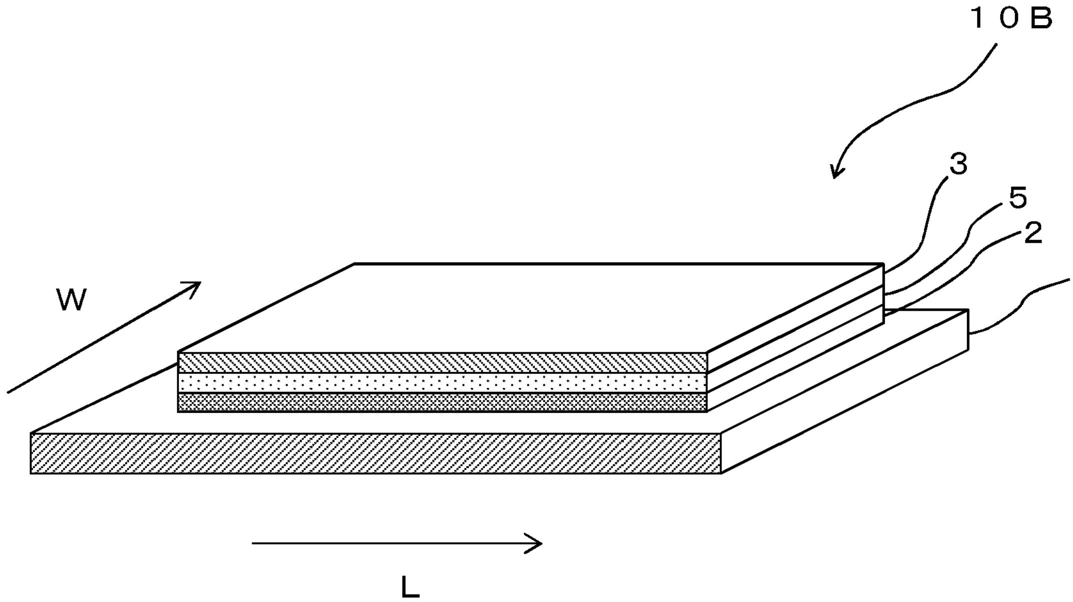

Ｆｉｇ．２

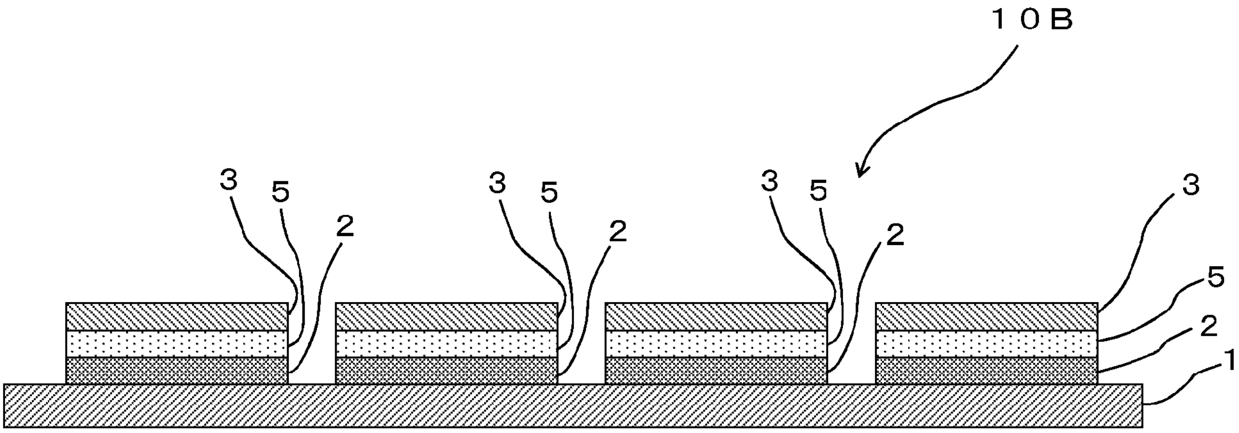


Ｆｉｇ．３Ａ

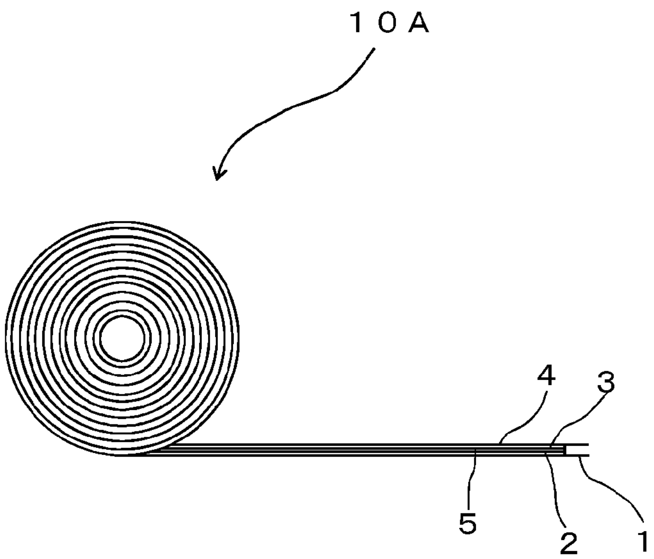

Ｆｉｇ．３Ｂ

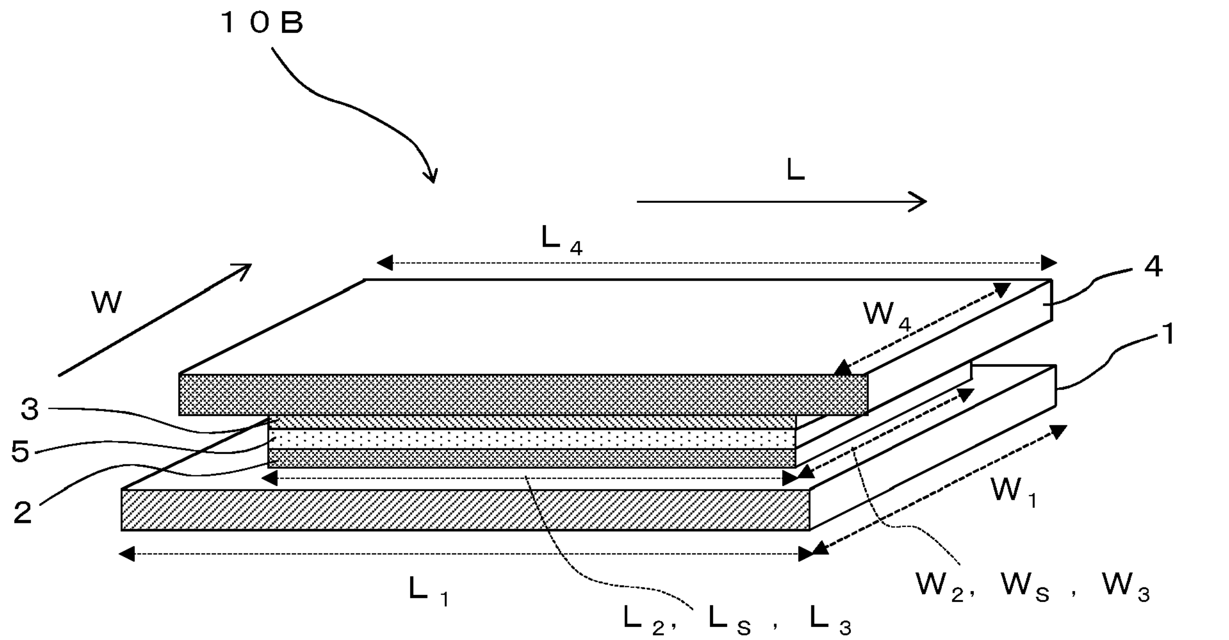


Ｆｉｇ．４Ａ

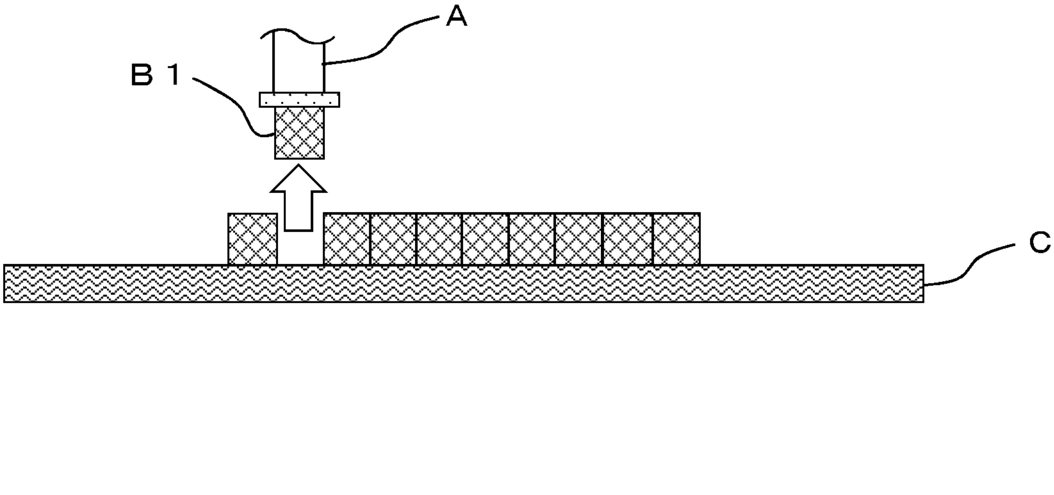

Ｆｉｇ．４Ｂ

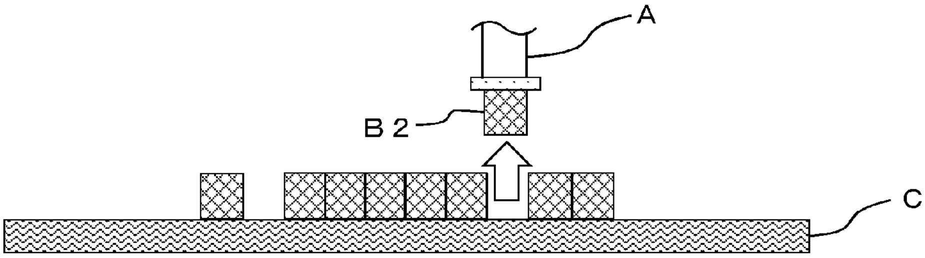


Ｆｉｇ．５

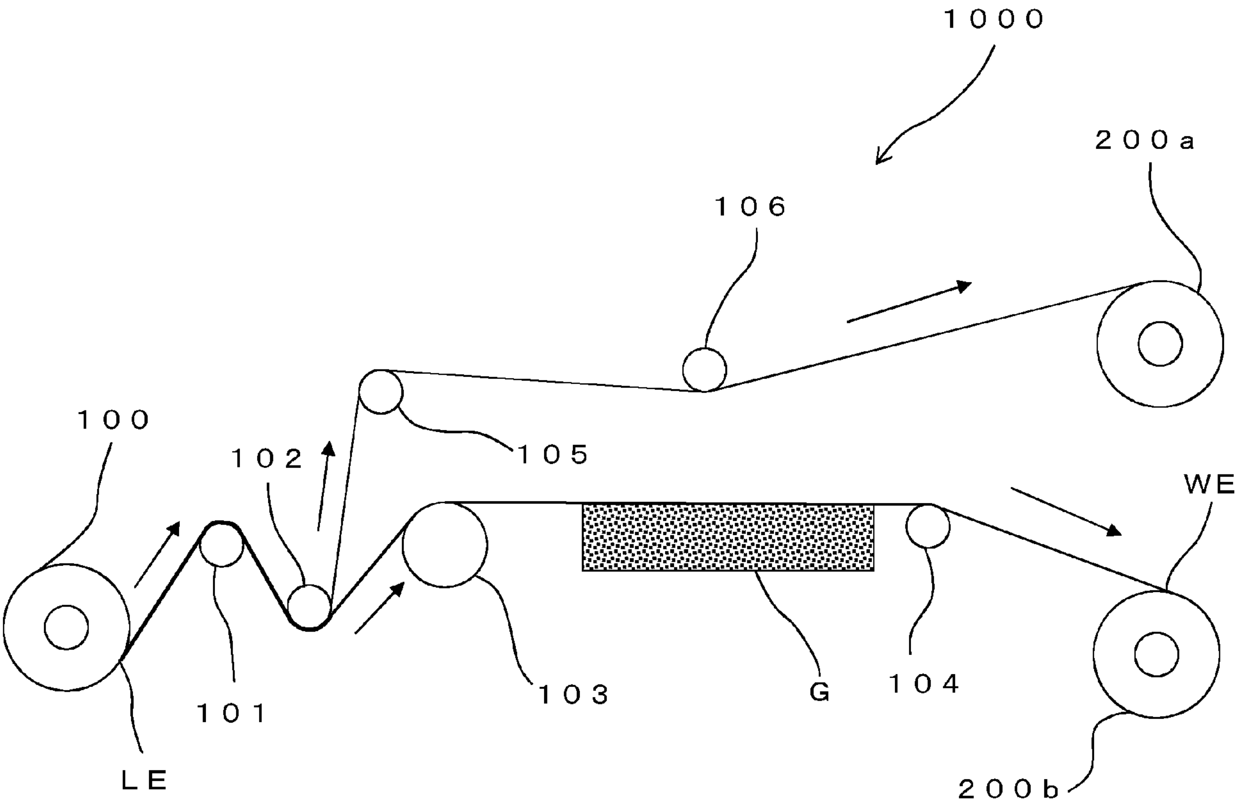

Ｆｉｇ．６Ａ

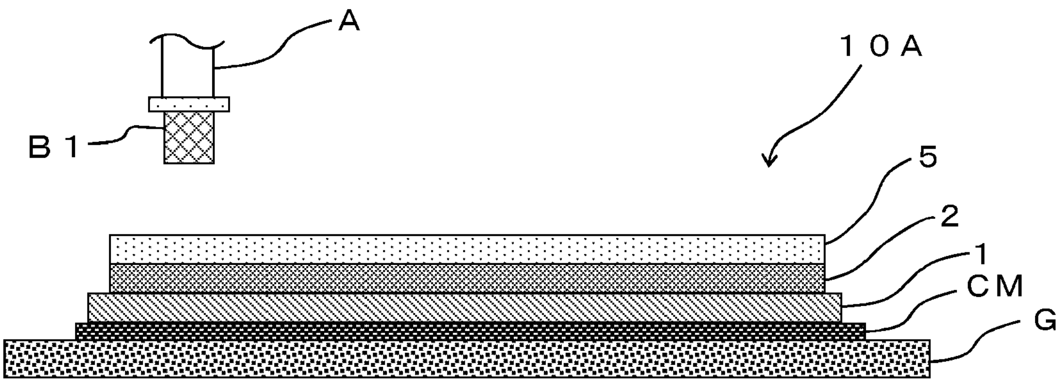


Ｆｉｇ．６Ｂ

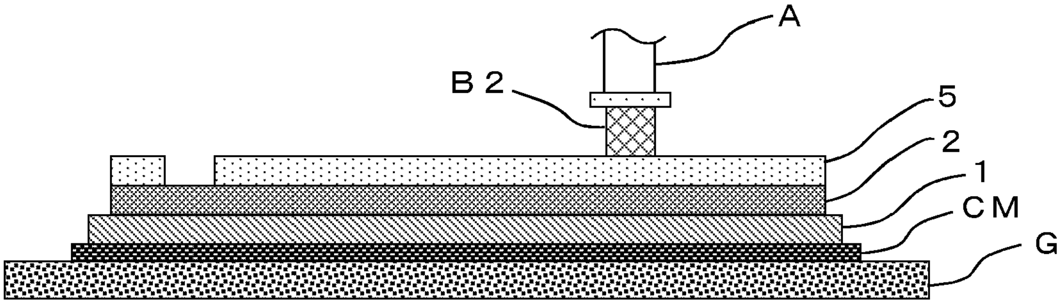

Ｆｉｇ．７Ａ

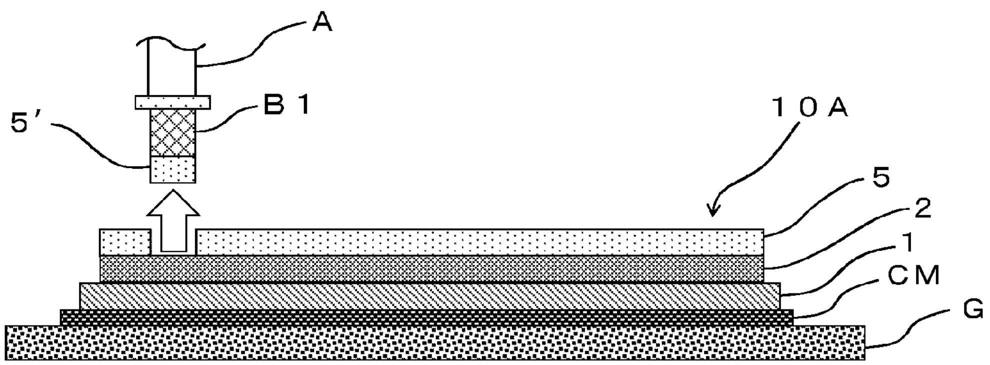


Ｆｉｇ．７Ｂ

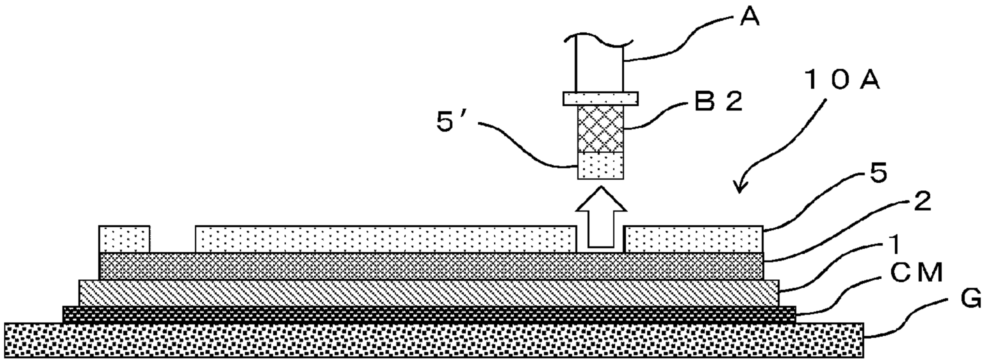


Ｆｉｇ８Ａ

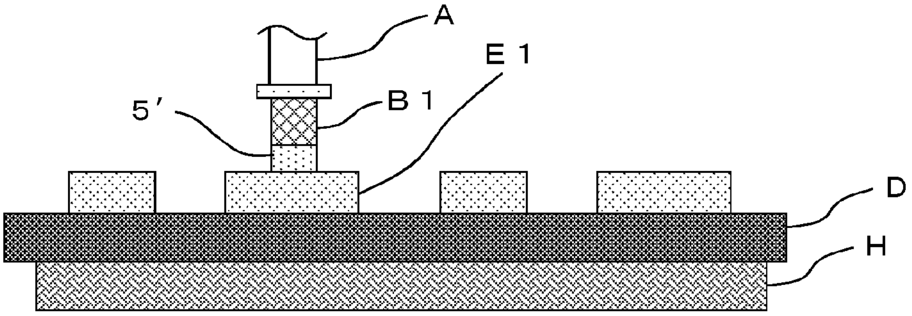

Fig. 8B

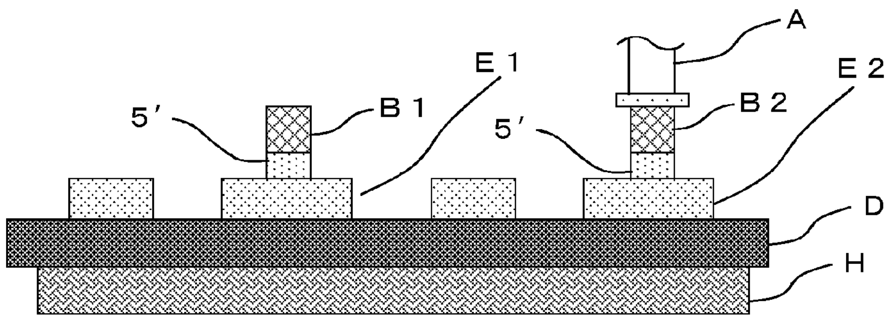


Fig. 9A

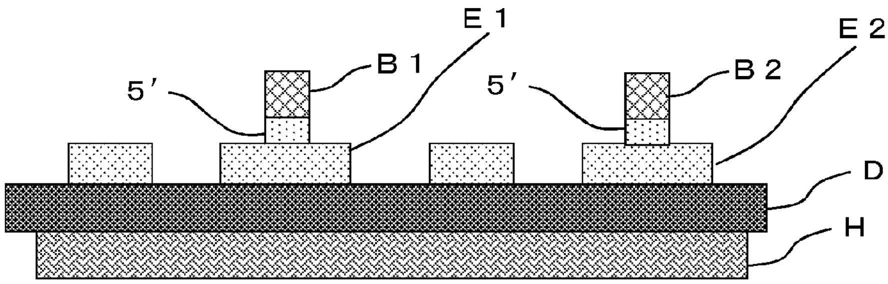


Fig. 9B

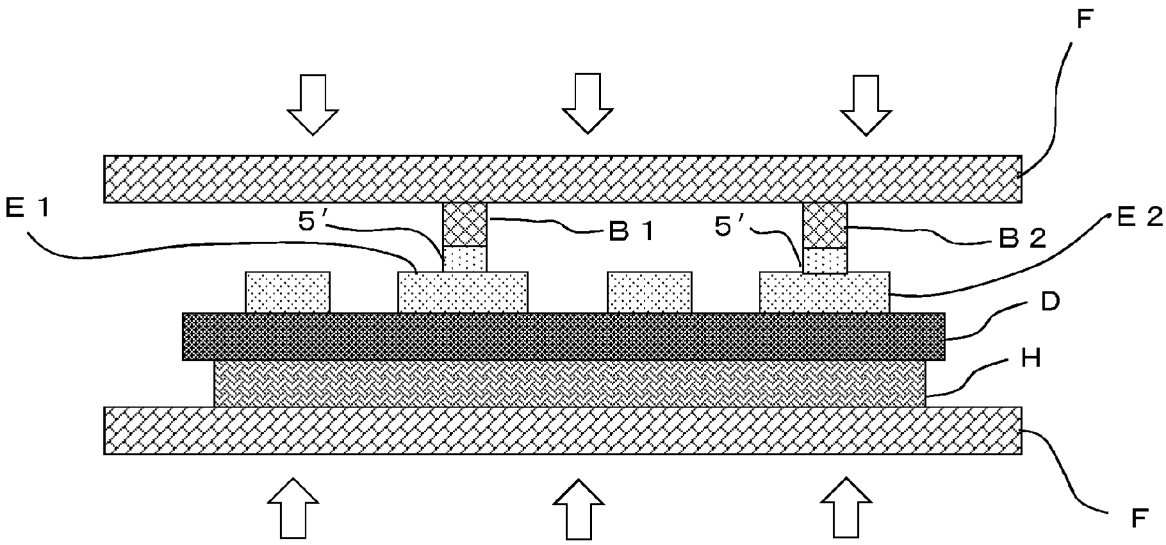

Europäisches Patentamt
European Patent Office
Office européen des brevets

# EUROPEAN SEARCH REPORT

Application Number
EP 24 17 9631

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2020/189535 A1 (LINTEC CORP [JP]) 24 September 2020 (2020-09-24)<br>* abstract *<br>* paragraph [0015] - paragraph [0017]; figure 1 *<br>* paragraph [0030] - paragraph [0032] *<br>* paragraph [0033] - paragraph [0041] *<br>* paragraph [0042] - paragraph [0051] *<br>* paragraph [0055] - paragraph [0060] *<br>* paragraphs [0068], [0073] *<br>* paragraph [0177] - paragraph [0181]; figure 4 *<br>* paragraph [0182] - paragraph [0188]; figure 5 *<br>----- | 1,3,4,6, 11-14<br>2,5,7-10 | INV.<br>H01L23/00 |
| X<br>A | EP 3 358 609 A1 (NITTO DENKO CORP [JP]) 8 August 2018 (2018-08-08)<br>* paragraphs [0001], [0002], [0009] - [0011] *<br>* paragraph [0014] - paragraph [0017]; figures 1,2 *<br>* paragraph [0023] - paragraph [0027] *<br>* paragraph [0028] - paragraph [0030] *<br>* paragraph [0031] *<br>* paragraph [0033] - paragraph [0036] *<br>----- | 1,2,5-14<br>3,4 | TECHNICAL FIELDS SEARCHED (IPC)<br>H01L |

The present search report has been drawn up for all claims

1

| Place of search | Date of completion of the search | Examiner |
|---|---|---|
| The Hague | 10 February 2025 | Keller, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 17 9631

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2025

| Patent document cited in search report | Publication date | Patent family member(s) | Publication date |
|---|---|---|---|
| WO 2020189535 A1 | 24-09-2020 | CN 113631373 A | 09-11-2021 |
| | | JP 7544686 B2 | 03-09-2024 |
| | | JP WO2020189535 A1 | 24-09-2020 |
| | | KR 20210141490 A | 23-11-2021 |
| | | TW 202045655 A | 16-12-2020 |
| | | WO 2020189535 A1 | 24-09-2020 |
| EP 3358609 A1 | 08-08-2018 | CN 108184331 A | 19-06-2018 |
| | | EP 3358609 A1 | 08-08-2018 |
| | | JP 6704322 B2 | 03-06-2020 |
| | | JP 2017069557 A | 06-04-2017 |
| | | TW 201731995 A | 16-09-2017 |
| | | US 2018273808 A1 | 27-09-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020150188 A
- JP 2020147706 A